# EUROPEAN PATENT APPLICATION

(11) **EP 4 644 792 A1**
(43) Date of publication of application: **05.11.2025**
(21) Application number: 24839871.1
(22) Date of filing: 25.04.2024
(51) Int. Cl.: F24F 1/22, H05K 7/14, F24F 1/56

(54) **OUTDOOR UNIT OF AIR CONDITIONER**

(30) Priority: 10.07.2023 KR 20230089449
(71) Applicant: Samsung Electronics Co., Ltd., Suwon-si, Gyeonggi-do 16677 (KR)
(72) Inventor: YUK, Chungwan, Suwon-si Gyeonggi-do 16677 (KR); KOH, Jeonguk, Suwon-si Gyeonggi-do 16677 (KR); SUN, Woong, Suwon-si Gyeonggi-do 16677 (KR); SHIN, Kwangnam, Suwon-si Gyeonggi-do 16677 (KR); YU, Jungho, Suwon-si Gyeonggi-do 16677 (KR); LEE, Jongmin, Suwon-si Gyeonggi-do 16677 (KR)
(74) Representative: Walaski, Jan Filip
(86) International application number: PCT/KR2024/005583
(87) International publication number: WO 2025/014054

(57) **Abstract**

An outdoor unit of an air conditioner comprises: a case; a board frame configured to move relative to the case and on which a printed circuit board is mounted; and a frame guide disposed inside the case and configured to support the board frame. The board frame is configured to slide between a first frame position with respect to the frame guide and a second frame position with respect to the frame guide, and to allow a sliding movement of the board frame to be guided by the frame guide. In response to the board frame being at the second frame position with respect to the frame guide, the board frame is configured to rotate about a rotation axis passing through the frame guide.

## Description

### [Technical Field]

The present disclosure relates to an outdoor unit of an air conditioner, and for example, to an outdoor unit of an air conditioner including a control box.

### [Background Art]

An air conditioner is a device that uses a refrigeration cycle to control temperature, humidity, airflow, and distribution air to be appropriate for human activities. Main components that form the refrigeration cycle include a compressor, a condenser, an evaporator, and a blower fan.

The air conditioner may be classified into a separate type in which an indoor unit and an outdoor unit are separately installed, and an integrated type in which both the indoor unit and the outdoor unit are installed in a single cabinet.

The outdoor unit of the separate type air conditioner may include an outdoor heat exchanger configured to exchange heat with outdoor air, a compressor configured to compress a refrigerant, an expansion valve unit configured to decompress the refrigerant, and a blower fan configured to generate an airflow. Additionally, the outdoor unit of the air conditioner includes a housing that accommodates the outdoor heat exchanger, the expansion valve unit, the compressor, and the blower fan. Additionally, a control box accommodating a printed circuit board assembly for controlling the air conditioner may be disposed inside the housing.

### [Disclosure]

### [Technical Problem]

Embodiments of the disclosure provide an outdoor unit of an air conditioner including an improved structure to improve space utilization of a control box.

Embodiments of the disclosure provide an outdoor unit of an air conditioner including an improved structure to facilitate inspection, replacement, and repair of components within a control box.

Embodiments of the disclosure provide an outdoor unit of an air conditioner including an improved structure to prevent and/or reduce damage to the product when performing tasks such as inspection, replacement, and repair of components in a control box.

Embodiments of the disclosure provide an air conditioner including an improved structure to improve accessibility to components within a control box.

Embodiments of the disclosure provide an air conditioner including an improved structure to reduce the number of components in a control box and to simplify a manufacturing process.

### [Technical Solution]

An outdoor unit of an air conditioner according to an example embodiment of the present disclosure may include: a case; a board frame configured to move relative to the case and on which a printed circuit board is mounted; and a frame guide disposed inside the case and configured to support the board frame. The board frame is configured to slide between a first frame position with respect to the frame guide; and a second frame position with respect to the frame guide, and to allow a sliding movement of the board frame to be guided by the frame guide. In response to the board frame being at the second frame position with respect to the frame guide, the board frame is configured to rotate about a rotation axis passing through the frame guide.

An outdoor unit of an air conditioner according to an example embodiment of the present disclosure may include: a case; a locker disposed in the case; and a board frame configured to move relative to the case and on which a printed circuit board is mounted. The board frame is configured to slide relative to the case between a first frame position in which a rotational movement with respect to the case is restricted by the locker and a second frame position separated from the locker. In response to the board frame being at the second frame position, the board frame is configured to rotate about a rotation axis passing through an inside of the case.

An outdoor unit of an air conditioner according to an example embodiment of the present disclosure may include: a first printed circuit board; a second printed circuit board; a case accommodating the first printed circuit board and the second printed circuit board; and a board frame configured to support the second printed circuit board and configured to move relative to the case. The board frame is configured to move in a first direction between a first frame position and a second frame position with respect to the case. At the first frame position, the board frame is restricted from moving in a second direction perpendicular to the first direction with respect to the case. Between the second frame position and a third frame position, the board frame is configured to rotate about a rotation axis perpendicular to the first direction and the second direction.

### [Description of Drawings]

The above and other aspects, features and advantages of certain embodiments of the present disclosure will be more apparent from the following detailed description, taken in conjunction with the accompanying drawings, in which:
FIG. 1 is a perspective view illustrating an air conditioner according to various embodiments;
FIG. 2 is a perspective view illustrating an outdoor unit of the air conditioner according to various embodiments;
FIG. 3 is an exploded perspective view of the outdoor unit of the air conditioner according to various embodiments;
FIG. 4 is an enlarged perspective view of a control box of the outdoor unit of the air conditioner according to various embodiments
FIG. 5 is a diagram illustrating the control box of the outdoor unit of the air conditioner when viewed from one direction according to various embodiments;
FIG. 6 is an exploded perspective view illustrating a second control box of the outdoor unit of the air conditioner according to various embodiments;
FIG. 7 is a perspective view illustrating a state in which a board frame is in a first frame position in the outdoor unit of the air conditioner according to various embodiments;
FIG. 8 is a perspective view illustrating a state in which the board frame is in a second frame position in the outdoor unit of the air conditioner according to various embodiments;
FIG. 9 is a perspective view illustrating a state in which the board frame is in a third frame position in the outdoor unit of the air conditioner according to various embodiments;
FIG. 10 is an enlarged perspective view illustrating a portion of a configuration when the board frame is in the first frame position in the outdoor unit of the air conditioner according to various embodiments;
FIG. 11 is an enlarged perspective view illustrating a portion of the configuration when the board frame is in the second frame position in the outdoor unit of the air conditioner according to various embodiments;
FIG. 12 is an enlarged perspective view illustrating a portion of the configuration when the board frame is in the third frame position in the outdoor unit of the air conditioner according to various embodiments;
FIG. 13 is a cross-sectional view illustrating a state in which the board frame is in the first frame position in the outdoor unit of the air conditioner according to various embodiments;
FIG. 14 is a cross-sectional view illustrating a state in which the board frame is in the second frame position in the outdoor unit of the air conditioner according to various embodiments;
FIG. 15 is a cross-sectional view illustrating a state in which the board frame is in the third frame position in the outdoor unit of the air conditioner according to various embodiments
FIG. 16 is an enlarged perspective view illustrating a portion of the configuration when the board frame is in the first frame position in the outdoor unit of the air conditioner according to various embodiments;
FIG. 17 is a cross-sectional view illustrating a state in which the board frame is in the first frame position in the outdoor unit of the air conditioner according to various embodiments;
FIG. 18 is a cross-sectional view illustrating a state in which the board frame is in the second frame position in the outdoor unit of the air conditioner according to various embodiments;
FIG. 19 is a cross-sectional view illustrating a state in which the board frame is in the third frame position in the outdoor unit of the air conditioner according to various embodiments
FIG. 20 is a perspective view illustrating a state in which the board frame is rotating from the second frame position to the third frame position in the outdoor unit of the air conditioner according to various embodiments;
FIG. 21 is a cross-sectional view illustrating the state in which the board frame is rotating from the second frame position to the third frame position in the outdoor unit of the air conditioner according to various embodiments;
FIG. 22 is a perspective view illustrating a state in which the board frame is rotating from the second frame position to the third frame position in the outdoor unit of the air conditioner according to various embodiments;
FIG. 23 is a cross-sectional view illustrating a state in which the board frame is rotating from the second frame position to the third frame position in the outdoor unit of the air conditioner according to various embodiments;
FIG. 24 is a perspective view illustrating a state in which the board frame is in the third frame position in the outdoor unit of the air conditioner according to various embodiments;
FIG. 25 is an enlarged perspective view illustrating a portion of the configuration of the outdoor unit of the air conditioner according to various embodiments;
FIG. 26 is a perspective view illustrating a portion of a configuration of a second control box of the outdoor unit of the air conditioner according to various embodiments;
FIG. 27 is a cross-sectional view illustrating a portion of a configuration of a second control box of the outdoor unit of the air conditioner according to various embodiments;
FIG. 28 is an enlarged perspective view illustrating a portion of a configuration when a board frame is in a third frame position in a second control box of the outdoor unit of the air conditioner according to various embodiments; and
FIG. 29 is a perspective view illustrating a portion of a configuration of a second control box of the outdoor unit of the air conditioner according to various embodiments.

### [Mode for Invention]

Various embodiments and the terms used therein are not intended to limit the technology disclosed herein to specific forms, and the disclosure should be understood to include various modifications, equivalents, and/or alternatives to the corresponding embodiments.

In describing the drawings, similar reference numerals may be used to designate similar elements.

A singular expression may include a plural expression unless otherwise indicated herein or clearly contradicted by context.

The terms "A or B," "at least one of A or/and B," or "one or more of A or/and B," A, B or C," "at least one of A, B or/and C," or "one or more of A, B or/and C," and the like used herein may include any and all combinations of one or more of the associated listed items.

The term of "and / or" includes a plurality of combinations of relevant items or any one item among a plurality of relevant items.

Herein, the expressions "a first", "a second", "the first", "the second", etc., may simply be used to distinguish an element from other elements, but is not limited to another aspect (e.g., importance or order) of elements.

When an element (e.g., a first element) is referred to as being "(functionally or communicatively) coupled," or "connected" to another element (e.g., a second element), the first element may be connected to the second element, directly (e.g., wired), wirelessly, or through a third element.

In this disclosure, the terms "including", "having", and the like are used to specify features, numbers, steps, operations, elements, components, or combinations thereof, but do not preclude the presence or addition of one or more of the features, numbers, steps, operations, elements, components, or combinations thereof.

When an element is said to be "connected", "coupled", "supported" or "contacted" with another element, this includes not only when elements are directly connected, coupled, supported or contacted, but also when elements are indirectly connected, coupled, supported or contacted through a third element.

Throughout the description, when an element is "on" another element, this includes not only when the element is in contact with the other element, but also when there is another element between the two elements.

An air conditioner according to various embodiments may refer to a device that performs functions such as purification, ventilation, humidity control, cooling or heating in an air conditioning space (hereinafter referred to as "indoor space"), and particularly a device having at least one of these functions.

According to an embodiment, an air conditioner may include a heat pump device to perform a cooling function or a heating function. The heat pump device may include a refrigeration cycle in which a refrigerant is circulated through a compressor, a first heat exchanger, and an expansion device and a second heat exchanger. All components of the heat pump device may be embedded in one housing forming an exterior of an air conditioner, which includes a window-type air conditioner or a portable air conditioner. On the other hand, some components of the heat pump device may be divided and embedded in a plurality of housings forming a single air conditioner, which includes a wall-mounted air conditioner, a stand-type air conditioner, and a system air conditioner.

The air conditioner including the plurality of housings may include at least one outdoor unit installed outdoors and at least one indoor unit installed indoors. For example, the air conditioner may be provided in such a way that a single outdoor unit and a single indoor unit are connected through a refrigerant pipe. Alternatively, the air conditioner may be provided in such a way that a single outdoor unit is connected to two or more indoor units through a refrigerant pipe. Alternatively, the air conditioner may be provided in such a way that two or more outdoor units and two or more indoor units are connected through a plurality of refrigerant pipes.

The outdoor unit may be electrically connected to the indoor unit. For example, information (or commands) for controlling the air conditioner may be received through an input interface provided in the outdoor unit or the indoor unit. The outdoor unit and the indoor unit may operate simultaneously or sequentially in response to a user input.

The air conditioner may include an outdoor heat exchanger provided in the outdoor unit, an indoor heat exchanger provided in the indoor unit, and a refrigerant pipe connecting the outdoor heat exchanger and the indoor heat exchanger.

The outdoor heat exchanger may be configured to exchange heat between a refrigerant and outdoor air through a phase change of the refrigerant (e.g., evaporation or condensation). For example, while the refrigerant is condensed in the outdoor heat exchanger, the refrigerant may radiate heat to the outdoor air. While the refrigerant flowing in the outdoor heat exchanger evaporates, the refrigerant may absorb heat from the outdoor air.

The indoor unit is intended to be installed indoors. For example, according to the arrangement method of the indoor unit, the air conditioner may be classified into a ceiling-type indoor unit, a stand-type indoor unit, a wall-mounted indoor unit, and the like. For example, the ceiling-type indoor unit may be classified into a 4-way type indoor unit, a 1-way type indoor unit, a duct type indoor unit and the like according to a method of discharging air.

As mentioned above, the indoor heat exchanger may be configured to exchange heat between a refrigerant and outdoor air through a phase change of the refrigerant (e.g., evaporation or condensation). For example, while the refrigerant evaporates in the indoor unit, the refrigerant may absorb heat from the indoor air. The indoor space may be cooled by blowing the indoor air cooled through the cooled indoor heat exchanger. While the refrigerant is condensed in the indoor heat exchanger, the refrigerant may radiate heat to the indoor air. The indoor space may be heated by blowing the indoor air heated through the high-temperature indoor heat exchanger.

In other words, the air conditioner may perform a cooling or heating function through a phase change process of a refrigerant circulating between the outdoor heat exchanger and the indoor heat exchanger. To circulate the refrigerant, the air conditioner may include a compressor for compressing the refrigerant. The compressor may intake refrigerant gas through an inlet and compress the refrigerant gas. The compressor may discharge high-temperature and high-pressure refrigerant gas through an outlet. The compressor may be disposed inside the outdoor unit.

Through the refrigerant pipe, the refrigerant may be sequentially circulated through the compressor, the outdoor heat exchanger, the expansion device, and the indoor heat exchanger or sequentially circulated through the compressor, the indoor heat exchanger, the expansion device, and the outdoor heat exchanger.

For example, in the air conditioner, when a single outdoor unit and a single indoor unit are directly connected through a refrigerant pipe, the refrigerant may be circulated between the single outdoor unit and the single indoor unit through the refrigerant pipe.

For example, in the air conditioner, when a single outdoor unit is connected to two or more indoor units through a refrigerant pipe, the refrigerant may flow from the single outdoor unit to the plurality of indoor units through branched refrigerant pipes. Refrigerants discharged from the plurality of indoor units may be combined and circulated to the outdoor unit. For example, through a separate refrigerant pipe, each of the plurality of indoor units may be directly connected in parallel to the single outdoor unit.

Each of the plurality of indoor units may be operated independently according to an operation mode set by a user. In other words, some of the plurality of indoor units may be operated in a cooling mode while others of the plurality of indoor units is operated in a heating mode. The refrigerant may be selectively introduced into each indoor unit in a high-pressure state or a low-pressure state, discharged, and circulated to the outdoor unit along a circulation path that is designated through a flow path switching valve to be described in greater detail below.

For example, in the air conditioner, when two or more outdoor units and two or more indoor units are connected through the plurality of refrigerant pipes, refrigerants discharged from the plurality of outdoor units may be combined and flow through one refrigerant pipe, and then diverged again at a certain point and introduced into the plurality of indoor units.

All of the plurality of outdoor units may be driven or at least some of the plurality of outdoor units may not be driven according to a driving load according to an operation amount of the plurality of indoor units. Through a flow path switching valve, the refrigerant may be provided to be introduced into and circulated to an outdoor unit that is selectively driven. The air conditioner may include the expansion device to lower the pressure of the refrigerant flowing into the heat exchanger. For example, the expansion device may be disposed inside the indoor unit or inside the outdoor unit, or disposed inside the indoor unit and the outdoor unit.

The expansion device may lower a temperature and pressure of the refrigerant using a throttling effect. The expansion device may include an orifice configured to reduce a cross-sectional area of a flow path. A temperature and pressure of the refrigerant passing through the orifice may be lowered.

For example, the expansion device may be implemented as an electronic expansion valve configured to adjust an opening ratio (a ratio of a cross-sectional area of a flow path of a valve in a partially opened state to a cross-sectional area of the flow path of the valve in a fully open state). According to the opening ratio of the electronic expansion valve, the amount of refrigerant passing through the expansion device may be adjusted.

The air conditioner may further include a flow path switching valve disposed on the refrigerant circulation path. The flow path switching valve may include a 4-way valve. The flow path switching valve may determine a refrigerant circulation path depending on an operation mode of the indoor unit (e.g., cooling operation or heating operation). The flow path switching valve may be connected to the outlet of the compressor.

The air conditioner may include an accumulator. The accumulator may be connected to the inlet of the compressor. A low-temperature and low-pressure refrigerant, which is evaporated in the indoor heat exchanger or the outdoor heat exchanger, may flow into the accumulator.

When a refrigerant mixture of refrigerant liquid and refrigerant gas is introduced, the accumulator may separate the refrigerant liquid from the refrigerant gas, and supply the refrigerant gas, from which the refrigerant liquid is separated, to the compressor.

An outdoor fan may be provided near the outdoor heat exchanger. The outdoor fan may blow outdoor air to the outdoor heat exchanger to promote heat exchange between the refrigerant and the outdoor air.

The outdoor unit of the air conditioner may include at least one sensor (hereinafter referred to as an outdoor unit sensor). For example, the sensor of the outdoor unit may be provided as an environment sensor. The outdoor unit sensor may be disposed at a certain position of the inside or the outside of the outdoor unit. For example, the outdoor unit sensor may include a temperature sensor configured to detect an air temperature around the outdoor unit, a humidity sensor configured to detect air humidity around the outdoor unit, or a refrigerant temperature sensor configured to detect a refrigerant temperature in a refrigerant pipe passing through the outdoor unit, or a refrigerant pressure sensor configured to detect a refrigerant pressure in a refrigerant pipe passing through the outdoor unit.

The outdoor unit of the air conditioner may include an outdoor unit communication circuitry. The outdoor unit communication circuitry may be configured to receive a control signal from an indoor unit controller of the air conditioner, which will be described in greater detail below. Based on a control signal received through the outdoor unit communication circuitry, the outdoor unit may control the operation of the compressor, the outdoor heat exchanger, the expansion device, the flow path switching valve, the accumulator, or the outdoor fan. The outdoor unit may transmit a sensing value detected by the outdoor unit sensor to the indoor unit controller through the outdoor unit communication circuitry.

The indoor unit of the air conditioner may include a housing, a blower configured to circulate air inside or outside the housing, and the indoor heat exchanger configured to exchange heat with air introduced into the housing.

The housing may include an inlet. Indoor air may flow into the housing through the inlet.

The indoor unit of the air conditioner may include a filter provided to filter out foreign substance in air that is introduced into the inside of the housing through the inlet.

The housing may include an outlet. Air flowing inside the housing may be discharged to the outside of the housing through the outlet.

An airflow guide configured to guide a direction of air discharged through the outlet may be provided in the housing of the indoor unit. For example, the airflow guide may include a blade positioned in the outlet. For example, the airflow guide may include an auxiliary fan for regulating an exhaust airflow, but is not limited thereto. Alternatively, the airflow guide may be omitted.

The indoor heat exchanger and the blower arranged on a flow path connecting the inlet and the outlet may be disposed inside the housing of the indoor unit.

The blower may include an indoor fan and a fan motor. For example, the indoor fan may include an axial fan, a mixed flow fan, a crossflow fan and a centrifugal fan.

The indoor heat exchanger may be arranged between the blower and the outlet or between the inlet and the blower. The indoor heat exchanger may absorb heat from air introduced through the inlet or transfer heat to air introduced through the inlet. The indoor heat exchanger may include a heat exchange tube through which a refrigerant flows, and a heat exchanger fin in contact with the heat exchange tube to increase a heat transfer area.

The indoor unit of the air conditioner may include a drain tray disposed below the indoor heat exchanger to collect condensed water generated in the indoor heat exchanger. The condensed water contained in the drain tray may be drained to the outside through a drain hose. The drain tray may be provided to support the indoor heat exchanger.

The indoor unit of the air conditioner may include an input interface. The input interface may include any type of user input means including a button, a switch, a touch screen and/or a touch pad. A user can directly input setting data (e.g., desired indoor temperature, cooling/ heating/ dehumidifying/air cleaning operation mode setting, outlet selection setting, and /or air volume setting) through the input interface.

The input interface may be connected to an external input device. For example, the input interface may be electrically connected to a wired remote controller. The wired remote controller may be installed at a specific location (e.g., a part of a wall) in an indoor space. A user can input setting data related to the operation of the air conditioner by manipulating the wired remote controller. An electrical signal corresponding to the setting data obtained through the wired remote controller may be transmitted to the input interface. Further, the input interface may include an infrared sensor. A user can remotely input the setting data for the operation of the air conditioner using a wireless remote controller. The setting data received through the wireless remote controller may be transmitted to the input interface as an infrared signal.

Further, the input interface may include a microphone. A user's voice command may be obtained through the microphone. The microphone may convert a user's voice command into an electrical signal and transmit the electrical signal to the indoor unit controller. The indoor unit controller may control components of the air conditioner to execute a function corresponding to the user's voice command. The setting data obtained through the input interface (e.g., desired indoor temperature, cooling/ heating/ dehumidifying/air cleaning operation mode setting, outlet selection setting, and /or air volume setting) may be transmitted to the indoor unit controller to be described in greater detail below. For example, the setting data obtained through the input interface may be transmitted to the outside, that is, to the outdoor unit or a server through an indoor unit communication circuitry to be described in greater detail below.

The indoor unit of the air conditioner may include a power module including power supply circuitry. The power module may be connected to an external power source to supply power to components of the indoor unit.

The indoor unit of the air conditioner may include an indoor unit sensor. The indoor unit sensor may be an environment sensor disposed inside or outside the housing. For example, the indoor unit sensor may include one or more temperature sensors and/or humidity sensors disposed in a predetermined space inside or outside the housing of the indoor unit. For example, the indoor unit sensor may include a refrigerant temperature sensor configured to detect a refrigerant temperature of a refrigerant pipe passing through the indoor unit. For example, the indoor unit sensor may include a refrigerant temperature sensor configured to detect a temperature of an entrance, a middle portion and/or an exit of the refrigerant pipe passing through the indoor heat exchanger.

For example, each environmental information detected by the indoor unit sensor may be transmitted to the indoor unit controller to be described in greater detail below or transmitted to the outside through the indoor unit communication circuitry to be described in greater detail below.

The indoor unit of the air conditioner may include the indoor unit communication circuitry. The indoor unit communication circuitry may include at least one of a short-range wireless communication module and a long-range wireless communication module. The indoor unit communication circuitry may include at least one antenna for wirelessly communicating with other devices. The outdoor unit may include the outdoor unit communication circuitry. The outdoor unit communication circuitry may also include at least one of a short-range wireless communication module and a long-range wireless communication module.

The short-range wireless communication module may include a Bluetooth communication module, a Bluetooth Low Energy (BLE) communication module, a near field communication module, a WLAN (Wi-Fi) communication module, and a Zigbee communication module, an infrared data association (IrDA) communication module, a Wi-Fi Direct (WFD) communication module, an ultrawideband (UWB) communication module, an Ant+ communication module, a microwave (uWave) communication module, etc., but is not limited thereto.

The long-range wireless communication module may include a communication module that performs various types of long-range wireless communication, and may include a mobile communication circuitry. The mobile communication circuitry transmits and receives radio signals with at least one of a base station, an external terminal, and a server on a mobile communication network.

The indoor unit communication circuitry may communicate with an external device such as a server, a mobile device and other home appliances through an access point (AP). The access point (AP) may connect a local area network (LAN), to which an air conditioner or a user device is connected, to a wide area network (WAN) to which a server is connected. The air conditioner or the user device may be connected to the server through the wide area network (WAN). The indoor unit of the air conditioner may include the indoor unit controller configured to control components of the indoor unit including the blower. The outdoor unit of the air conditioner may include an outdoor unit controller configured to control components of the outdoor unit including the compressor. The indoor unit controller may communicate with the outdoor unit controller through the indoor unit communication circuitry and the outdoor unit communication circuitry. The outdoor unit communication circuitry may transmit a control signal generated by the outdoor unit controller to the indoor unit communication circuitry, or transmit a control signal, which is transmitted from the indoor unit communication circuitry, to the outdoor unit controller. In other words, the outdoor unit and the indoor unit may perform bi-directional communication. The outdoor unit and the indoor unit may transmit and receive various signals generated during operation of the air conditioner.

The outdoor unit controller may be electrically connected to components of the outdoor unit and may control operations of each component. For example, the outdoor unit controller may adjust a frequency of the compressor and control the flow path switching valve to change a circulation direction of the refrigerant. The outdoor unit controller may adjust a rotational speed of the outdoor fan. Further, the outdoor unit controller may generate a control signal for adjusting the opening degree of the expansion valve. Under the control of the outdoor unit controller, the refrigerant may be circulated along the refrigerant circulation circuit including the compressor, the flow path switching valve, the outdoor heat exchanger, the expansion valve, and the indoor heat exchanger.

Various temperature sensors included in the outdoor unit and the indoor unit may transmit electrical signals corresponding to detected temperatures to the outdoor unit controller and/or the indoor unit controller. For example, the humidity sensors included in the outdoor unit and the indoor unit may respectively transmit electrical signals corresponding to the detected humidity to the outdoor unit controller and/or the indoor unit controller.

The indoor unit controller may obtain a user input from a user device including a mobile device through the indoor unit communication circuitry, or directly obtain a user input through the input interface or the remote controller. The indoor unit controller may control components of the indoor unit including the blower in response to the received user input. The indoor unit controller may transmit information related to the received user input to the outdoor unit controller of the outdoor unit.

The outdoor unit controller may control components of the outdoor unit including the compressor based on the information related to the user input received from the indoor unit. For example, when a control signal corresponding to a user input for selecting an operation mode such as a cooling operation, a heating operation, a fan operation, a defrosting operation, or a dehumidifying operation is received from the indoor unit, the outdoor unit controller may control components of the outdoor unit to perform an operation of the air conditioner corresponding to the selected operation mode.

The outdoor unit controller and indoor unit controller may include a processor and a memory, respectively. The indoor unit controller may include at least one first processor and at least one first memory, and the outdoor unit controller may include at least one second processor and at least one second memory.

The memory may memorize/store various types of information necessary for the operation of the air conditioner. The memory may store instructions, applications, data and/or programs necessary for the operation of the air conditioner. For example, the memory may store various programs for the cooling operation, the heating operation, the dehumidifying operation, and /or the defrosting operation of the air conditioner. The memory may include volatile memory such as a static random access memory (S-RAM) and a dynamic random access memory (D-RAM) for temporarily storing data. In addition, the memory may include a non-volatile memory such as a read only memory (ROM), an erasable programmable read only memory (EPROM), and an electrically erasable programmable read only memory (EEPROM) for long-term storage of data.

The processor may generate a control signal for controlling an operation of the air conditioner based on instructions, applications, data, and/or programs stored in the memory. The processor may be hardware and may include a logic circuit and an arithmetic circuit. The processor may process data according to a program and/or instructions provided from the memory, and may generate a control signal according to a processing result. The memory and the processor may be implemented as one control circuit or as a plurality of circuits. The processor according to an embodiment of the disclosure may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions.

The indoor unit of the air conditioner may include an output interface. The output interface may be electrically connected to the indoor unit controller, and output information related to the operation of the air conditioner under the control of the indoor unit controller. For example, the output interface may output information such as an operation mode selected by a user input, a wind direction, a wind volume, and a temperature. Further, the output interface may output sensing information obtained from the indoor unit sensor or the outdoor unit sensor, and output warning /error messages.

The output interfaces may include a display and a speaker. The speaker may be a sound device and configured to output various sounds. The display may display information, which is input by a user or provided to a user, as various graphic elements. For example, operation information of the air conditioner may be displayed as at least one of an image and text. Further, the display may include an indicator providing specific information. The display may include a liquid crystal display (LCD) panel, a light emitting diode (LED) panel, an organic light emitting diode (OLED) panel, a micro-LED panel, and/or a plurality of LEDs.

Hereinafter various example embodiments according to the present disclosure will be described in greater detail with reference to the attached drawings.

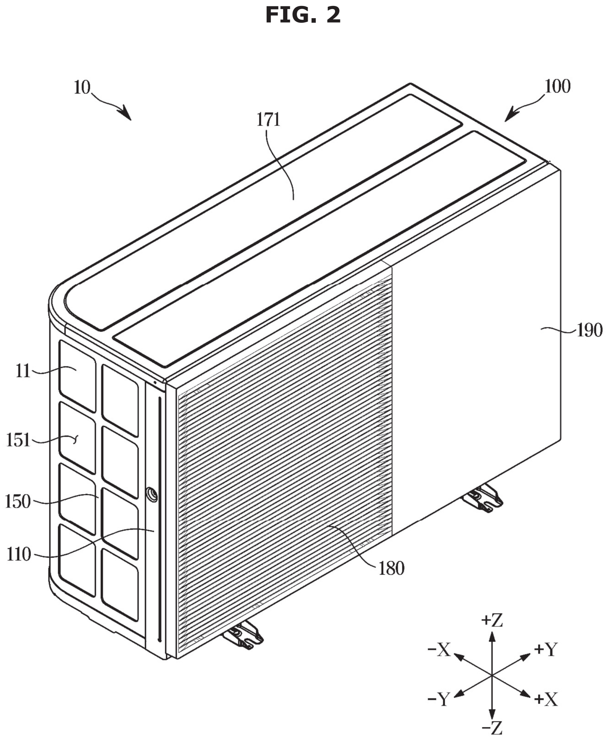

The terms "upward," "downward," "forward," "rearward," etc. used in the following description are defined based on the drawings, and the shape and location of each component are not limited by these terms. For example, when referring to FIG. 2, a direction in which an outlet grille 180 and a front cover 190 each face in an outdoor unit 10 of an air conditioner 1 according to an embodiment of the present disclosure may be defined as forward (+X direction), and a direction opposite to the forward may be defined as rearward (-X direction). Further, a vertical direction in which a top cover 171 of the outdoor unit 10 of the air conditioner 1 faces may be defined as upward (+Z direction) and a direction opposite to the upward may be defined as downward (-Z direction). Further, a direction in which a first side frame 150 of the outdoor unit of the air conditioner 1 is positioned may be defined as left direction (-Y direction), and a direction opposite to the left direction may be defined as right direction (+Y direction).

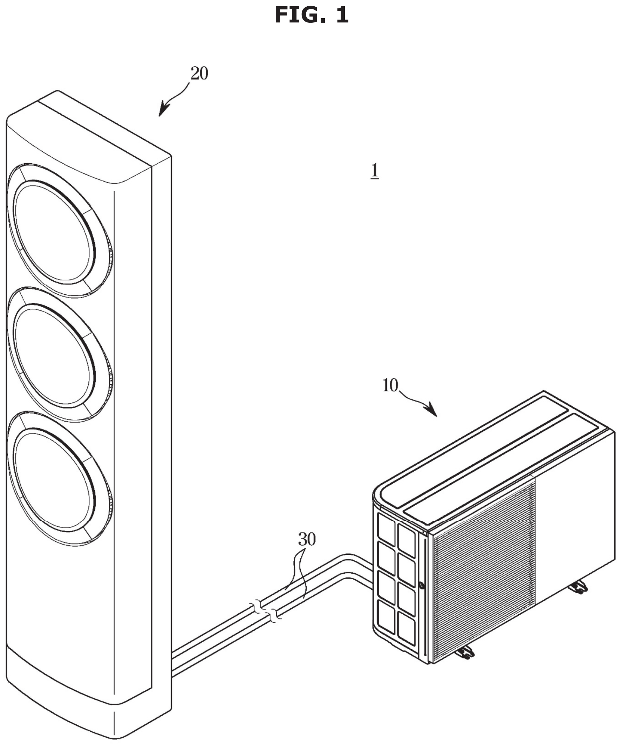

FIG. 1 is a perspective view illustrating an air conditioner according to various embodiments.

Referring to FIG. 1, the air conditioner 1 according to an embodiment of the present disclosure may include an indoor unit 20 disposed in an indoor space and the outdoor unit 10 disposed in an outdoor space.

In order to cool an air conditioning space that is subject to air conditioning, the air conditioner 1 may absorb heat from an inside of the air conditioning space and emit heat to an outside of the air conditioning space. Further, in order to heat the air conditioning space, the air conditioner 1 may absorb heat from the outside of the air conditioning space and emit heat to the inside of the air conditioning space.

On the outside of the air conditioning space, the outdoor unit 10 may exchange heat with outdoor air. The outdoor unit 10 may perform heat exchange between a refrigerant and outdoor air using a phase change (e.g., evaporation or condensation) of the refrigerant. For example, the outdoor unit 10 may emit heat from the refrigerant to the outdoor air using the condensation of the refrigerant. Additionally, the outdoor unit 10 may absorb heat from outdoor air into the refrigerant using the evaporation of the refrigerant.

FIG. 1 illustrates a single outdoor unit 10, but the number of outdoor units 10 is not limited to that shown in FIG. 1. For example, the air conditioner 1 may include a plurality of outdoor units.

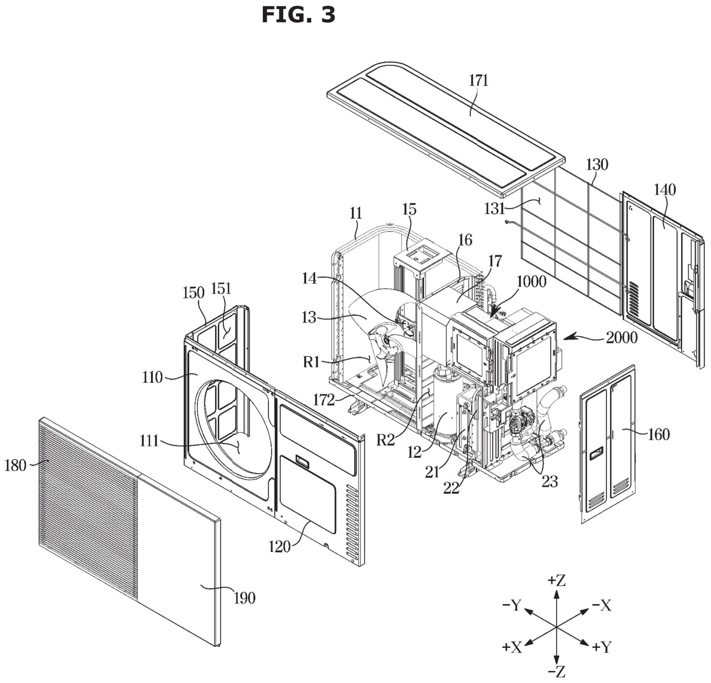

The outdoor unit 10 may include an outdoor heat exchanger 11 (refer to FIG. 3) configured to exchange heat with outdoor air, and a compressor 12 (refer to FIG. 3) configured to compress refrigerant gas.

A configuration of the outdoor unit 10 will be described in greater detail below.

The indoor unit 20 may exchange heat with indoor air within the air conditioning space. The indoor unit 20 may perform heat exchange between the refrigerant and indoor air using a phase change (e.g., evaporation or condensation) of the refrigerant. For example, the indoor unit 20 may cool the air conditioning space by absorbing heat from indoor air into the refrigerant using the evaporation of the refrigerant. Further, the indoor unit 20 may heat the air conditioning space by discharging heat from the refrigerant to the indoor air using the condensation of the refrigerant.

The indoor unit 20 may include an indoor heat exchanger configured to exchange heat with indoor air, an indoor blower fan configured to draw and blow indoor air to allow the indoor air to pass through the indoor heat exchanger, and an expansion valve unit configured to decompress and expand the refrigerant.

FIG.1 illustrates a single indoor unit 20, but the number of indoor units 20 is not limited to that shown in FIG. 1. For example, the air conditioner 1 may include a plurality of indoor units. A plurality of different indoor units may be respectively installed in a plurality of different air conditioning spaces.

As mentioned above, the air conditioner 1 may perform the heat exchange between the refrigerant and outdoor air on the outside of the air conditioning space and perform the heat exchange between the refrigerant and indoor air within the air conditioning space.

The air conditioner 1 may include a refrigerant pipe 30 provided to transfer the refrigerant between the indoor unit 20 and the outdoor unit 10 in order to move heat between the outside of the air conditioning space and the inside of the air conditioning space. The refrigerant pipe 30 may move the refrigerant between the outside of the air conditioning space and the inside of the air conditioning space. The indoor unit 20 and the outdoor unit 10 may be connected to each other through the refrigerant pipe 30 provided to transfer the refrigerant.

The above-mentioned air conditioner 1 is merely an example of the air conditioner to which the outdoor unit of the air conditioner according to the present disclosure is applied, but the present disclosure is not limited thereto. The configuration of the air conditioner to which the outdoor unit of the air conditioner according to the present disclosure is applied, the indoor unit included therein, the refrigerant pipe, etc. may vary.

Hereinafter the outdoor unit 10 of the air conditioner 1 according to an embodiment of the present disclosure will be described in greater detail with reference to FIGS. 2 to 29.

FIG. 2 is a perspective view illustrating an outdoor unit of the air conditioner according to various embodiments. FIG. 3 is an exploded perspective view of the outdoor unit of the air conditioner according to various embodiments.

Referring to FIGS. 2 and 3, the outdoor unit 10 of the air conditioner 1 according to an embodiment of the present disclosure may include the outdoor heat exchanger 11 configured to exchange heat with outdoor air, the compressor 12 configured to compress a refrigerant, an outdoor fan 13 configured to draw and blow outdoor air to allow the outdoor air to pass through the outdoor heat exchanger 11, and a housing 100 provided to form an exterior of the outdoor unit 10.

The housing 100 may form the exterior of the outdoor unit 10. Various components of the outdoor unit 10, such as the outdoor heat exchanger 11, the compressor 12, the outdoor fan 13, and control boxes 1000 and 2000 to be described in greater detail below, may be accommodated inside the housing 100.

The housing 100 may include inlets 131 and 151 through which air flows in and an outlet 111 through which air flows out. As the outdoor fan 13 rotates, air outside the housing 100 may be introduced through the inlets 131 and 151, and after exchanging heat with the outdoor heat exchanger 11, the air may be discharged to the outside of the housing 100 through the outlet 111.

The outdoor unit 10 may include a heat exchange room R1 formed inside the housing 100. Outside air may be introduced into the heat exchange room R1, and the introduced air may be discharged to the outside again. In the heat exchange room R1, heat exchange may occur between the outdoor heat exchanger 11 and air introduced from the outside. Components such as the outdoor heat exchanger 11 and the outdoor fan 13 may be disposed in the heat exchange room R1.

The outdoor unit 10 may include a machine room R2 formed inside the housing 100. Components such as the compressor 12 and the control boxes 1000 and 2000, which will be described in greater detail below, may be disposed in the machine room R2.

In the housing 100, the heat exchange room R1 and the machine room R2 may be partitioned from each other. The outdoor unit 10 may include a partition 16 provided to define the heat exchange room R1 and the machine room R2. The partition 16 may be disposed between the heat exchange room R1 and the machine room R2. For example, the heat exchange room R1 and the machine room R2 may be arranged in the left and right directions (Y direction) in the drawing, and the partition 16 may be arranged to extend in the up and down direction (Z direction) in the drawing, and the partition 16 may define the heat exchange room R1 and machine room R2.

For example, the housing 100 may be formed to have a substantially box shape.

Hereinafter an example of a structure of the housing 100 will be described in greater detail.

The housing 100 may include a first front frame 110. The first front frame 110 may cover the front (+X direction) of the heat exchange room R1. The outlet 111 may be formed in the first front frame 110.

The housing 100 may include a second front frame 120. The second front frame 120 may cover the front (+X direction) of the machine room R2. For example, the second front frame 120 may be formed in a substantially flat plate shape.

For example, the first front frame 110 and the second front frame 120 may be arranged side by side in the left and right direction (Y direction). The first front frame 110 and the second front frame 120 may be coupled to each other.

For example, a plurality of heat dissipation holes may be formed in the second front frame 120 to allow the machine room R2 to communicate with the outside of the outdoor unit 10 so as to dissipate heat within the machine room R2.

The housing 100 may include a first rear frame 130. The first rear frame 130 may form a part of a rear exterior of the outdoor unit 10. The first rear frame 130 may be disposed at the rear (-X direction) of the heat exchange room R1. An inlet 131 may be formed in the first rear frame 130.

The first front frame 110 and the first rear frame 130 may be arranged to face each other.

The housing 100 may include a second rear frame 140. The second rear frame 140 may form another part of the rear exterior of the outdoor unit 10. The second rear frame 140 may cover the rear (-X direction) of the machine room R2.

For example, a plurality of heat dissipation holes may be formed in the second rear frame 140 to allow the machine room R2 to communicate with the outside of the outdoor unit 10 to dissipate heat within the machine room R2.

The second front frame 120 and the second rear frame 140 may be arranged to face each other.

The housing 100 may include the first side frame 150. The first side frame 150 may form one surface of the outdoor unit 10 in the left direction (-Y direction).

The first side frame 150 may cover the heat exchange room R1. The first side frame 150 may cover the heat exchange room R1 from the left direction (-Y direction). An inlet 151 may be formed in the first side frame 150.

The first side frame 150 may be coupled to the first front frame 110. The first side frame 150 may be connected to the first rear frame 130.

For example, the first side frame 150 may be arranged to extend in the front and rear direction (X direction).

The housing 100 may include a second side frame 160. The second side frame 160 may form one surface of the outdoor unit 10 in the right direction (+Y direction).

The second side frame 160 may cover the machine room R2. The second side frame 160 may cover the machine room R2 from the right direction (+Y direction).

For example, a plurality of heat dissipation holes may be formed in the second side frame 160 to allow the machine room R2 to communicate with the outside of the outdoor unit 10 so as to dissipate heat within the machine room R2.

The second side frame 160 may be coupled to the second front frame 120. The second side frame 160 may be coupled to the second rear frame 140.

For example, the second side frame 160 may be arranged to extend in the front and rear direction (X direction).

The first side frame 150 and the second side frame 160 may be disposed to face each other.

The housing 100 may include a base 172. The base 172 may form a lower surface of the outdoor unit 10. The base 172 may be disposed on one side of the heat exchange room R1 and the machine room R2 with respect to the lower side (-Z direction). The base 172 may support various components of the outdoor unit 10 accommodated inside the housing 100 from the lower side.

The base 172 may be coupled to a lower portion of each of the first front frame 110, the second front frame 120, the second rear frame 140, the first side frame 150, and the second side frame 160.

The base 172 may be formed to have a substantially flat plate shape.

The housing 100 may include the top cover 171. The top cover 171 may form an upper surface of the outdoor unit 10.

The top cover 171 may cover an upper side (+Z direction) of the heat exchange room R1 and the machine room R2. The top cover 171 may cover various components of the outdoor unit 10 accommodated inside the housing 100 from the upper side.

The top cover 171 may be coupled to an upper portion of each of the first front frame 110, the second front frame 120, the second rear frame 140, the first side frame 150, and the second side frame 160.

The top cover 171 may be formed to have a substantially flat plate shape.

The top cover 171 and the base 172 may be arranged to face each other.

The housing 100 may include the outlet grille 180. The outlet grille 180 may cover the front (+X) of the first front frame 110. The outlet grille 180 may cover the front (+X) of the outlet 111. The outlet grille 180 may be coupled to the first front frame 110. The outlet grille 180 may form a portion of a front exterior of the outdoor unit 10.

The outlet grille 180 may have a substantially grille shape to allow air to be discharged from the outlet while covering the outlet 111.

The housing 100 may include the front cover 190. The front cover 190 may cover the front (+X) of the second front frame 120. The front cover 190 may be coupled to the second front frame 120. The front cover 190 may form another portion of the front exterior of the outdoor unit 10.

For example, the outlet grille 180 and the front cover 190 may be arranged side by side in the left and right direction (Y direction). The outlet grille 180 and the front cover 190 may be coupled to each other.

Components disposed in the housing 100 may be provided to be separable from each other. For example, the second front frame 120 may be provided to be separable from the first front frame 110, the second side frame 160, the top cover 171, and the base 172. For example, the second side frame 160 may be provided to be separable from the second front frame 120, the second rear frame 140, the top cover 171, and the base 172. For example, the top cover 171 may be provided to be separable from the first front frame 110, the second front frame 120, the second rear frame 140, the first side frame 150, and the second side frame 160.

Accordingly, when it is necessary to perform tasks such as inspecting, replacing, or repairing components in the outdoor unit 10, a worker can perform the tasks by separating at least one component of the housing 100.

The configuration of the housing included in the air conditioner according to the present disclosure is not limited to the above-mentioned description.

The outdoor heat exchanger 11 may be configured to exchange heat with outdoor air. The outdoor heat exchanger 11 may be configured to allow a refrigerant to flow therein. In the outdoor heat exchanger 11, the heat exchange may occur between the refrigerant and the outdoor air.

For example, during a cooling operation of the air conditioner 1, high-pressure and high-temperature refrigerant gas may be condensed in the outdoor heat exchanger 11, and while the refrigerant is condensed, the refrigerant may emit heat to the outdoor air. During the cooling operation of the air conditioner 1, the outdoor heat exchanger 11 may discharge a refrigerant liquid.

In addition, during a heating operation of the air conditioner 1, low-temperature and low-pressure refrigerant liquid may be evaporated in the outdoor heat exchanger 11, and while the refrigerant is evaporated, the refrigerant may absorb heat from the outdoor air. During the heating operation of the air conditioner 1, the outdoor heat exchanger 11 may discharge refrigerant gas.

In the heat exchange room R1, the outdoor heat exchanger 11 may be arranged to face the inlets 131 and 151.

The compressor 12 may compress refrigerant gas and discharge high-temperature and high-pressure refrigerant gas. For example, the compressor 12 may include a motor and a compression mechanism, and the compression mechanism may compress the refrigerant gas by a torque of the motor.

The outdoor unit 10 may include the outdoor fan 13 configured to move air, and a fan motor 14 configured to generate a rotational force to rotate the outdoor fan 13.

For example, the outdoor unit 10 may include a motor bracket 15 provided to support the outdoor fan 13 and the fan motor 14. The motor bracket 15 may be disposed in the heat exchange room R1.

For example, the outdoor unit 10 may include a plate heat exchanger 21. The plate heat exchanger 21 may be configured to exchange heat between the refrigerant and water. The plate heat exchanger 21 may be disposed inside the housing 100. For example, the plate heat exchanger 21 may be disposed in the machine room R2.

For example, the outdoor unit 10 may include a water pipe 23 provided to allow water to be introduced from the outside or discharged to the outside. The water pipe 23 may be connected to the plate heat exchanger 21. At least a portion of the water pipe 23 may be disposed inside the housing 100. For example, at least a portion of the water pipe 23 may be disposed in the machine room R2.

Water that is introduced from the outside through the water pipe 23 may exchange heat with a high-temperature refrigerant within the plate heat exchanger 21. In the plate heat exchanger 21, water may absorb heat from the high-temperature refrigerant and transfer the heat back to the outside of the outdoor unit 10 through the water pipe 23.

For example, the outdoor unit 10 may include an expansion tank 22. When the water temperature rises due to the plate heat exchanger 21, a volume of the water within the water pipe 23 may increase, and the expansion tank 22 may be provided to prevent and/or reduce the sudden increase in the water pressure. The expansion tank 22 may be disposed inside the housing 100. For example, the expansion tank 22 may be disposed in the machine room R2.

As mentioned above, the outdoor unit 10 according to an embodiment may include the plate heat exchanger 21, the water pipe 23, and the expansion tank 22, thereby forming a part of a heating system configured to supply hot water.

However, the present disclosure is not limited thereto, and in the air conditioner according to an embodiment, the plate heat exchanger, the water pipe, and the expansion tank may be disposed outside the outdoor unit. Alternatively, the air conditioner according to an embodiment may not be equipped with the heating system.

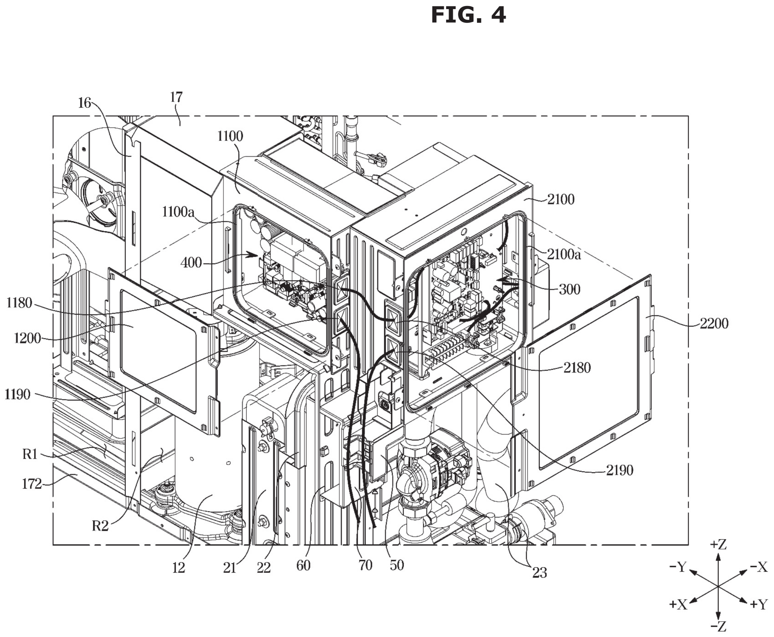

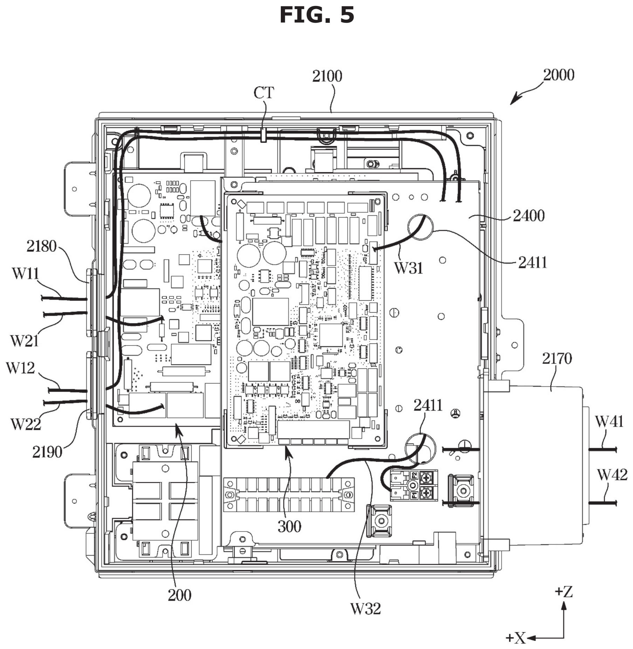

The outdoor unit 10 may include a plurality of printed circuit boards (PCBs) 200, 300, and 400 (refer to FIGS. 4, 5, etc.) for controlling the operation of various components of the outdoor unit 10. Various electronic components may be mounted on the plurality of printed circuit boards 200, 300, and 400. The outdoor unit 10 may include the control boxes 1000 and 2000 to accommodate the plurality of printed circuit boards 200, 300 and 400.

For example, the outdoor unit 10 may include a first control box 1000. The first control box 1000 may be accommodated inside the housing 100. For example, the first control box 1000 may be disposed in the machine room R2.

As illustrated in FIG. 3, the first control box 1000 may be located in the front portion of the machine room R2 and may be covered by the second front frame 120.

For example, the outdoor unit 10 may include a second control box 2000. The second control box 2000 may be accommodated inside the housing 100. For example, the second control box 2000 may be disposed in the machine room R2.

As illustrated in FIG. 3, the second control box 2000 may be located on a right portion of the machine room R2 and may be covered by the second side frame 160.

For example, the outdoor unit 10 may include a duct 17. The duct 17 may be provided to allow an inside of the first control box 1000 to communicate with the heat exchange room R1. Alternatively, the duct 17 may be provided to allow an inside of the second control box 2000 to communicate with the heat exchange room R1.

When the outdoor fan 13 is driven, air may flow from each of the first control box 1000 and the second control box 2000 to the heat exchange room R1 through the duct 17 due to the suction force of the outdoor fan 13. Accordingly, heat generated inside the first control box 1000 and the second control box 2000 may be dissipated to the outside.

The configuration of the outdoor unit 10 described above is only an example of the outdoor unit of the air conditioner according to the present disclosure, and the present disclosure is not limited thereto. The outdoor unit of the air conditioner according to the present disclosure may be configured in various ways to allow outside air to be introduced through the inlet and to allow the introduced air to be discharged to the outside after the heat exchange.

FIG. 4 is an enlarged perspective view of a control box of the outdoor unit of the air conditioner according to various embodiments.

Referring to FIG. 4, the outdoor unit 10 of the air conditioner 1 according to an embodiment of the present disclosure may include the first control box 1000 and the second control box 2000.

The first control box 1000 and the second control box 2000 may be provided to accommodate some of the plurality of printed circuit boards provided in the outdoor unit 10, respectively.

For example, the outdoor unit 10 may include a first printed circuit board 200 (refer to FIG. 5), a second printed circuit board 300, and a third printed circuit board 400. The first control box 1000 and the second control box 2000 may be provided to accommodate some of the first printed circuit board 200 (refer to FIG. 5), the second printed circuit board 300, and the third printed circuit board 400, respectively.

For example, the first printed circuit board 200 (refer to FIG. 5) may be accommodated in the second control box 2000. For example, the second printed circuit board 300 may be accommodated in the second control box 2000. For example, the third printed circuit board 400 may be accommodated in the first control box 1000.

The first control box 1000 may include a first case 1100. For example, the first case 1100 may be provided to accommodate the third printed circuit board 400. The first case 1100 may include an accommodating space in which the third printed circuit board 400 is accommodated.

The first case 1100 may be formed with one open side. For example, the first case 1100 may include a first case opening 1100a formed on one side. For example, the third printed circuit board 400 may be inserted into or withdrawn from the first case 1100 through the first case opening 1100a. A worker can perform a task by accessing the third printed circuit board 400 accommodated inside the first case 1100 through the first case opening 1100a.

For example, the first case opening 1100a may be formed on one side of the front (+X direction) of the first case 1100. That is, the first case 1100 may be formed to allow the front (+X direction) to be open. However, the present disclosure is not limited thereto, and a direction in which one side of the first case 1100 is open may be designed in various ways according to factors such as the location of the first case 1100 within the housing 100.

For example, the first case 1100 may be formed to have a substantially box shape.

The first control box 1000 may include a first case cover 1200 provided to be removably coupled to the first case 1100. The first case cover 1200 may be coupled to the first case 1100 to close the first case opening 1100a. The first case cover 1200 may be separated from the first case 1100 to open the first case opening 1100a. For example, a manufacturer of the first control box 1000 inserts the third printed circuit board 400 into the first case 1100 and then couples the first case cover 1200 to the first case 1100, thereby covering an internal space of the first case 1100. A worker who needs to inspect, replace, or repair a component of the third printed circuit board 400 inside the first control box 1000 can access the third printed circuit board 400 by separating the first case cover 1200 from the first case 1100.

For example, the first case cover 1200 may be coupled to the front (+X direction) of the first case 1100. That is, the first case cover 1200 may cover the third printed circuit board 400 from the front (+X direction).

For example, the first case cover 1200 may be formed in a substantially flat plate shape.

As mentioned above, the third printed circuit board 400 inside the first case 1100 may be protected from external shock, foreign substances introduced from the outside, leaked refrigerant gas, etc. by the first case cover 1200 in normal times. In addition, as the first case cover is separated as necessary, a worker can access the third printed circuit board 400.

The second control box 2000 may include a second case 2100. For example, the second case 2100 may be provided to accommodate the first printed circuit board 200 (refer to FIG. 5) and the second printed circuit board 300. The second case 2100 may include an accommodating space for accommodating the first printed circuit board 200 (refer to FIG. 5) and the second printed circuit board 300.

The second case 2100 may be formed with one open side. That is, the second case 2100 may include a second case opening 2100a formed on one side. For example, the first printed circuit board 200 (refer to FIG. 5) and the second printed circuit board 300 may be inserted into or withdrawn from the second case 2100 through the second case opening 2100a. A worker can perform a task by accessing the first printed circuit board 200 (refer to FIG. 5) or the second printed circuit board 300, which is accommodated inside the second case 2100, through the second case opening 2100a.

For example, the second case opening 2100a may be formed on one side of the second case 2100 in the right direction (+Y direction). That is, the second case 2100 may be formed to be open in the right direction (+Y direction). However, the present disclosure is not limited thereto, and the direction in which one side of the second case 2100 is open may be designed in various ways according to factors such as the location of the second case 2100 within the housing 100.

For example, the second case 2100 may be formed to have a substantially box shape.

The second control box 2000 may include a second case cover 2200 provided to be removably coupled to the second case 2100. The second case cover 2200 may be coupled to the second case 2100 to close the second case opening 2100a. The second case cover 2200 may be separated from the second case 2100 to open the second case opening 2100a. For example, a manufacturer of the second control box 2000 inserts the first printed circuit board 200 (refer to FIG. 5) and the second printed circuit board 300 into the second case 2100 and then couple the second case cover 2200 to the second case 2100, thereby covering an internal space of the second case 2100. A worker who needs to inspect, replace, or repair a component of the first printed circuit board 200 (refer to FIG. 5) or the second printed circuit board 300 inside the second control box 2000 can access the first printed circuit board 200 (refer to FIG. 5) and the second printed circuit board 300 by separating the second case cover 2200 from the second case 2100.

For example, the second case cover 2200 may be coupled to the right side (+Y direction) of the second case 2100. That is, the second case cover 2200 may cover the first printed circuit board 200 (refer to FIG. 5) and the second printed circuit board 300 from the right direction (+Y direction).

For example, the second case cover 2200 may be formed in a substantially flat plate shape.

As mentioned above, the first printed circuit board 200 (refer to FIG. 5) and the second printed circuit board 300 inside the second case 2100 may be protected from external shock, foreign substances introduced from the outside, leaked refrigerant gas, etc. by the second case cover 2200 in normal times. In addition, as the second case cover 2200 is separated as necessary, a worker can access the first printed circuit board 200 (refer to FIG. 5) or the second printed circuit board 300.

A structure of the second control box 2000 will be described in greater detail below.

The plurality of printed circuit boards arranged in the outdoor unit 10 may be configured to control an operation of various components of the outdoor unit 10, such as the compressor 12, the fan motor 14, the plate heat exchanger 21, and the expansion tank 22. The plurality of printed circuit boards 200, 300, and 400 may be provided to receive detection signals from various sensors (not shown) provided in the compressor 12, the outdoor heat exchanger 11, etc. The plurality of printed circuit boards may be electrically connected to various components of the outdoor unit 10 through wires.

For example, the first printed circuit board 200 (refer to FIG. 5), the second printed circuit board 300, and the third printed circuit board 400 may be electrically connected to various components of the outdoor unit 10 through wires. The first printed circuit board 200, the second printed circuit board 300, and the third printed circuit board 400 may be electrically connected to each other through wires. The first printed circuit board 200, the second printed circuit board 300, and the third printed circuit board 400 may be connected to devices (not shown) located outside the outdoor unit 10 through wires.

For example, the first printed circuit board 200 (refer to FIG. 5) may be connected to the third printed circuit board 400 through a wire that penetrates the first case 1100 and the second case 2100. For example, the first printed circuit board 200 may be connected to various components of the outdoor unit 10 through a wire that penetrates the second case 2100. For example, the first printed circuit board 200 may be connected to the second printed circuit board 300 through a wire disposed inside the second case 2100.

For example, the second printed circuit board 300 may be connected to the third printed circuit board 400 through a wire that penetrates the first case 1100 and the second case 2100. For example, the second printed circuit board 300 may be connected to various components of the outdoor unit 10 through a wire that penetrates the second case 2100. For example, the second printed circuit board 300 may be connected to the first printed circuit board 200 (refer to FIG. 5) through a wire disposed inside the second case 2100.

For example, the third printed circuit board 400 may be connected to the first printed circuit board 200 (refer to FIG. 5) or the second printed circuit board 300 through a wire that penetrates the first case 1100 and the second case 2100. For example, the third printed circuit board 400 may be connected to various components of the outdoor unit 10 through a wire that penetrates the second case 2100.

The first case 1100 may include wire penetrating portions 1180 and 1190 through which a wire penetrates. For example, the first case 1100 may include a first wire penetrating portion 1180 provided to allow a wire, which connects the third printed circuit board 400 to the first printed circuit board 200 (refer to FIG. 5) or the second printed circuit board 300, to penetrate therethrough. For example, the first case 1100 may include a second wire penetrating portion 1190 to allow a wire, which connects the third printed circuit board 400 to various components of the outdoor unit 10, to penetrate therethrough.

For example, the first wire penetrating portion 1180 may be disposed above the second wire penetrating portion 1190, but is not limited thereto.

For example, the wire penetrating portions 1180 and 1190 of the first case 1100 may be provided on one side of the first case 1100 adjacent to the second case 2100. For example, the wire penetrating portions 1180 and 1190 of the first case 1100 may be provided on a right surface (+Y direction side) of the first case 1100.

The second case 2100 may include wire penetrating portions 2180 and 2190 through which a wire penetrates. For example, the second case 2100 may include a third wire penetrating portion 2180 provided to allow a wire, which connects the first printed circuit board 200 (refer to FIG. 5) or the second printed circuit board 300 to the third printed circuit board 400, to penetrate therethrough. For example, the second case 2100 may include a fourth wire penetrating portion 2190 to allow a wire, which connects the first printed circuit board 200 (refer to FIG. 5) or the second printed circuit board 300 to various components of the outdoor unit 10, to penetrate therethrough.

For example, the third wire penetrating portion 2180 may be disposed above the fourth wire penetrating portion 2190, but is not limited thereto.

For example, the wire penetrating portions 2180 and 2190 of the second case 2100 may be provided on one side of the second case 2100 adjacent to the first case 1100. For example, the wire penetrating portions 2180 and 2190 of the second case 2100 may be provided on a front surface (+X direction side) of the second case 2100.

The outdoor unit 10 may include a wire guide 50. The wire guide 50 may be provided to fix/support some of the wires connected to the first printed circuit board 200 (refer to FIG. 5), the second printed circuit board 300, and the third printed circuit board 400. For example, the wire guide 50 may be provided to fix/support the wires passing through the second wire penetrating portion 1190 and the fourth wire penetrating portion 2290.

The first control box 1000 and the second control box 2000 may be supported within the housing 100.

For example, the outdoor unit 10 may include a first support frame 60 provided inside the housing 100. For example, the first support frame 60 may support lower portions of the first control box 1000 and the second control box 2000. For example, the first support frame 60 may be supported by the base 172.

For example, the outdoor unit 10 may include a second support frame 70 provided inside the housing 100. For example, the second support frame 70 may support a lower portion of the second control box 2000. For example, the second support frame 70 may be supported by the first support frame 60.

The configuration of the first control box 1000 and the second control box 2000 described above is merely an example of the control boxes included in the outdoor unit of the air conditioner according to the present disclosure and provided to accommodate the printed circuit boards. However, the present disclosure is not limited thereto.

FIG. 5 is a diagram illustrating the control box of the outdoor unit of the air conditioner when viewed from one direction according to various embodiments.

Referring to FIG. 5, the first printed circuit board 200 and the second printed circuit board 300 may be accommodated in the second control box 2000 of the outdoor unit 10 of the air conditioner 1 according to an embodiment of the present disclosure.

For example, as illustrated in FIG. 5, the first printed circuit board 200 may be disposed on the inner side of the second case 2100 rather than the second printed circuit board 300. That is, the first printed circuit board 200 may be disposed further from the second case opening 2100a of the second case 2100 than the second printed circuit board 300.

The position of the first printed circuit board 200 and the second printed circuit board 300 within the second case 2100 may be determined in consideration of installation stability, work efficiency, etc.

For example, the first printed circuit board 200 may be provided with a power connection terminal block to which a power connection wire for power supply is connected. At this time, in order to ensure the stability of power supply or to prevent and/or reduce a power connection wire, which is thick and inflexible, from being damaged by movement, the first printed circuit board 200 may be disposed on the inner side of the second case 2100 than the second printed circuit board 300, and the first printed circuit board 200 may be maintained in a fixed positioned.

For example, the first printed circuit board 200 may be mounted on an inner surface, which is provided on the other side opposite to one side in which the second case opening 2100a is formed, of the second case 2100.

For example, the second printed circuit board 300 may include a control circuit used for settings or inspection when installing the air conditioner 1 (electronic components with built-in software, and components such as displays for various controls for setting/inspection during installation may be included). Therefore, in order that a worker can easily access the second printed circuit board 300 and perform work efficiently, the second printed circuit board 300 may be disposed on the outer side of the second case 2100 than the first printed circuit board 200.

For example, the second printed circuit board 300 may be provided with a communication terminal block to which a communication wire for communicating with an external device is connected.

The second control box 2000 may include a board frame 2400. The board frame 2400 may be provided to support the second printed circuit board 300. The second printed circuit board 300 may be mounted on the board frame 2400.

For example, the second printed circuit board 300 may be provided to have a smaller area than the first printed circuit board 200 so as not to completely cover the first printed circuit board 200 when viewed through the second case opening 2100a. Similarly, the board frame 2400 may be provided to have a smaller area than the first printed circuit board 200 so as not to completely cover the first printed circuit board 200 when viewed through the second case opening 2100a.

As mentioned above, because the first printed circuit board 200 and the second printed circuit board 300 are accommodated together inside the second case 2100 in a multilayer structure arranged in the Y-direction, the space utilization of the second control box 2000 may be improved.

As illustrated in FIG. 5, through various wires W11, W12, W21, W22, W31, W32, W41, and W42, the first printed circuit board 200 and the second printed circuit board 300 may be connected to each other or may be connected to the third printed circuit board 400 or may be connected to other components of the outdoor unit 10 (the compressor 12, the fan motor 14, the plate heat exchanger 21, the expansion tank 22, various sensors, etc.) or may be connected to devices (not shown) outside the outdoor unit 10.

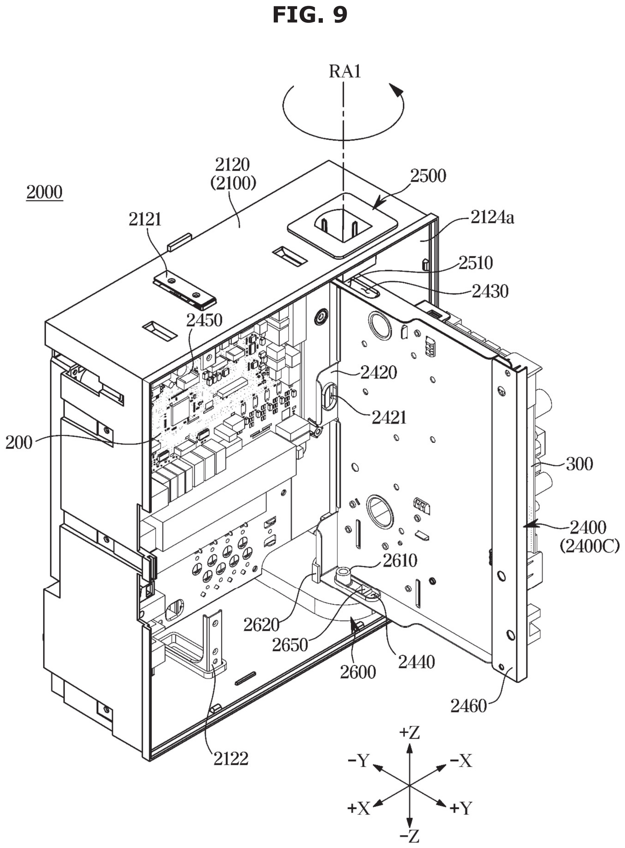

For example, wires W11 and W21 connecting the first printed circuit board 200 or the second printed circuit board 300 to the third printed circuit board 400 may be arranged to pass through the third wire penetrating portion 2180. The wire W11 connected to the second printed circuit board 300 may extend from the third wire penetrating portion 2180 along an inner edge of the second case 2100 and be connected to the second printed circuit board 300. Accordingly, it is possible to prevent and/or reduce the wire W11, which is connected to the second printed circuit board 300 at a relatively long distance from the third wire penetrating portion 2180, from interfering with other components in the second control box 2000. In addition, the wire W11 connected to the second printed circuit board 300 may extend to a position adjacent to a rotation axis RA1 (refer to FIG. 9) of the second printed circuit board, which will be described in greater detail below, with respect to the X direction, along the inner edge of the second case 2100, and be bent and connected to electronic components of the second printed circuit board 300. Accordingly, when the board frame 2400, on which the second printed circuit board 300 is mounted, rotates, a distance in which the wire W11 moves may be reduced and interference with the wire W11 may be prevented and/or reduced, as will be described in greater detail below.

For example, the wires W11 and W21 connecting the first printed circuit board 200 or the second printed circuit board 300 to the third printed circuit board 400 may include a wire capable of supplying power to the third printed circuit board 400.

For example, the wires W12 and W22 connecting the first printed circuit board 200 or the second printed circuit board 300 to various components or sensors of the outdoor unit 10 may be arranged to pass through the fourth wire penetrating portion 2190. The wire W12 connected to the second printed circuit board 300 may extend from the third wire penetrating portion 2180 along the inner edge of the second case 2100, as described above, and be connected to the second printed circuit board 300. Similarly, the wire W12 connected to the second printed circuit board 300 may extend to a position adjacent to the rotation axis RA1 (refer to FIG. 9) of the second printed circuit board, which will be described in greater detail below, with respect to the X direction, along the inner edge of the second case 2100, and be bent and connected to electronic components of the second printed circuit board 300.

For example, the wires W11 and W12 connected to the second printed circuit board 300 by passing through the wire penetrating portions 2180 and 2190 of the second case 2100 may be firmly fixed to the inner edge of the case 2100 through a cable tie (CT).

For example, the wires W31 and W32 connecting the first printed circuit board 200 and the second printed circuit board 300 may be arranged to penetrate the board frame 2400, which will be described in greater detail below. For example, the board frame 2400 may include a wire through-hole 2411 through which the wires W31 and W32 connecting the first printed circuit board 200 and the second printed circuit board 300 pass. The wire through-hole 2411 may be formed on a mounting surface 2410, on which the second printed circuit board 300 is mounted, on the board frame 2400. For example, on the mounting surface 2410, the wire through-hole 2411 may be formed at a position adjacent to the rotation axis RA1 (refer to FIG. 9) of the board frame 2400. Accordingly, when the board frame 2400, on which the second printed circuit board 300 is mounted, rotates, a distance in which the wires W31 and W32 move may be reduced and interference with the wires W31 and W32 may be prevented and/or reduced, as will be described in greater detail below.

For example, the first printed circuit board 200 or the second printed circuit board 300 may be connected to an external power source to receive power from an external power source, or may be connected to wires W41 and W42 capable of transmitting a communication signal to an external device and receiving a communication signal from an external device. The second case 2100 may include an outside wire penetrating portion 2170 through which the wires W41 and W42 pass. For example, the outside wire penetrating portion 2170 may be formed on the rear (-X) side of the second case 2100.

The description of the functions and arrangements of the wires described above with reference to FIG. 5 is merely an example of the air conditioner according to the present disclosure, and the present disclosure is not limited thereto.

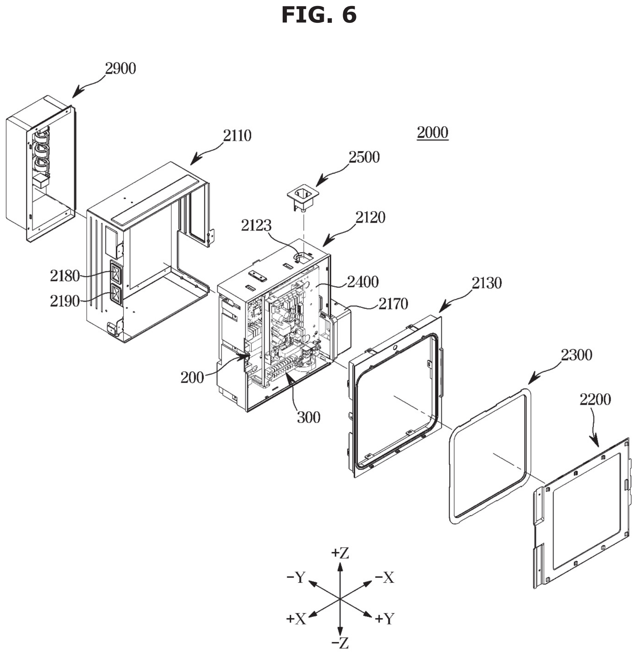

FIG. 6 is an exploded perspective view illustrating a second control box of the outdoor unit of the air conditioner according to various embodiments.

Referring to FIG. 6, the second case 2100 of the second control box 2000 included in the outdoor unit 10 of the air conditioner 1 according to an embodiment of the present disclosure may include an outer case 2110 and an inner case 2120.

The outer case 2110 may form an exterior of the second control box 2000. For example, the outer case 2110 may be coupled to the first support frame 60 and the second support frame 70, respectively. For example, the outer case 2110 may be provided with the third wire penetrating portion 2180 and the fourth wire penetrating portion 2190 described above.

The inner case 2120 may form an accommodating space in which the first printed circuit board 200 and the second printed circuit board 300 are accommodated. In addition, the board frame 2400 may also be accommodated in the accommodating space of the inner case 2120.

The inner case 2120 may be coupled to the inside of the outer case 2110.

The inner case 2120 may include a guide mounting portion 2123 on which a first frame guide 2500, which will be described in greater detail below, is mounted. The first frame guide 2500 may be removably mounted on the guide mounting portion 2123. The guide mounting portion 2123 may be formed to penetrate one surface of the inner case 2120. A portion of the first frame guide 2500 may penetrate the guide mounting portion 2123 and be placed inside the inner case 2120, and another portion may be supported by an outer surface of the inner case 2120. For example, as illustrated in FIG. 6, the guide mounting portion 2123 may be formed on an upper surface of the inner case 2120.

The second case 2100 may include a frame 2130. The frame 2130 may be formed along a circumference of the second case opening 2100a. For example, the frame 2130 may be coupled to one side of the inner case 2120 in the direction of the second case opening 2100a.

The above-described second case cover 2200 may be coupled to the frame 2130 to close the second case opening 2100a.

For example, the second control box 2000 may include a gasket 2300. The gasket 2300 may be provided to seal a gap between the second case cover 2200 and the frame 2130 when the second case cover 2200 is coupled to the frame 2130. Accordingly, it is possible to prevent and/or reduce foreign substances or leaked refrigerant, which is outside the second case 2100, from moving into the second case 2100.

For example, the second control box 2000 may include a noise filter 2900 provided to reduce current noise. For example, the noise filter 2900 may be coupled to the left side (-Y direction) of the second case 2100.

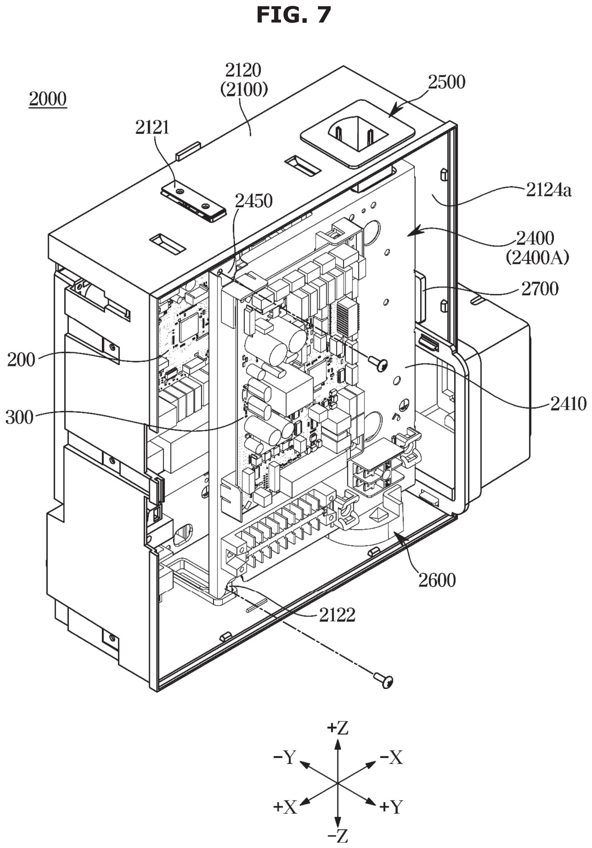

Hereinafter the structure of the second control box 2000 of the outdoor unit 10 of the air conditioner 1 according to an embodiment of the present disclosure will be described in greater detail with reference to FIGS. 7 to 29.

Hereinafter for convenience of description, the second control box 2000 may be referred to as 'control box 2000', the second case 2100 may be referred to as 'case 2100', and the second case opening 2100a may be referred to as 'case opening 2100a', and the second case cover 2200 may be referred to as 'case cover 2200'.

Hereinafter for convenience of description, based on the drawings, the X direction may be referred to as 'first direction', the Y direction may be referred to as 'second direction', and the Z direction may be referred to as 'third direction'. The first direction X, the second direction Y, and the third direction Z may be perpendicular to each other.

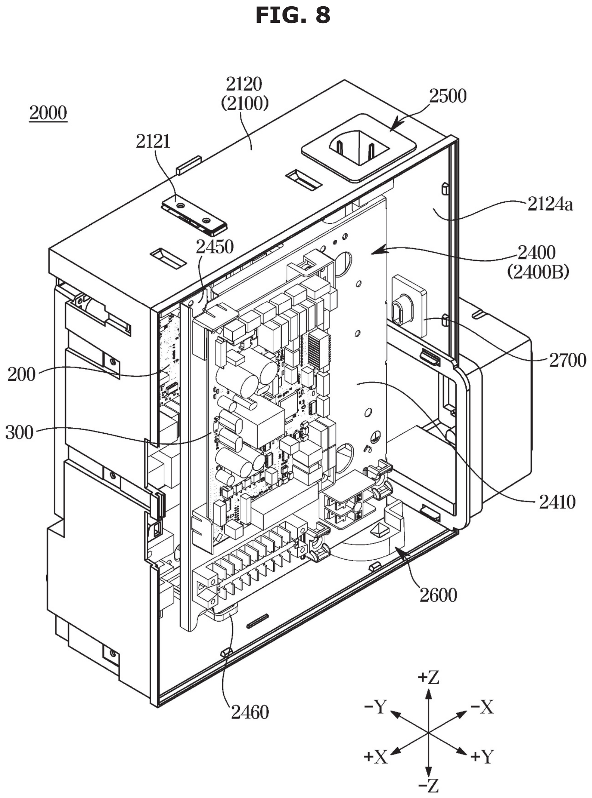

FIG. 7 is a perspective view illustrating a state in which a board frame is in a first frame position in the outdoor unit of the air conditioner according to various embodiments. FIG. 8 is a perspective view illustrating a state in which the board frame is in a second frame position in the outdoor unit of the air conditioner according to various embodiments. FIG. 9 is a perspective view illustrating a state in which the board frame is in a third frame position in the outdoor unit of the air conditioner according to various embodiments.

Referring to FIGS. 7 and 8, as for the outdoor unit 10 of the air conditioner 1 according to an embodiment of the present disclosure, when the case cover 2200 is separated from the case 2100 of the control box 2000, the first printed circuit board 200 and the second printed circuit board 300 accommodated therein may be provided to be accessible from the outside.

For example, a worker who needs to access the first printed circuit board 200 or the second printed circuit board 300 to inspect, replace, or repair components can sequentially separate the second side frame 160 of the outdoor unit 10 (refer to FIG. 3) and the case cover 2200 of the control box 2000, and then access the first printed circuit board 200 or the second printed circuit board 300 through the opened case opening 2100a.

However, in the state shown in FIG. 7, a portion of the first printed circuit board 200 may be covered by the second printed circuit board 300 and the board frame 2400 supporting the second printed circuit board 300, and thus the accessibility of the first printed circuit board 200 may be reduced. Accordingly, the worker's work efficiency on the first printed circuit board 200 may be reduced.

To ease the difficulty, the board frame 2400 included in the outdoor unit 10 of the air conditioner 1 according to an embodiment of the present disclosure may be configured to move with respect to the case 2100.

The second printed circuit board 300 may be mounted on the board frame 2400. The board frame 2400 may include the mounting surface 2410 on which the second printed circuit board 300 is mounted.

The second printed circuit board 300 may be mounted on the board frame 2400 in various ways, such as screw fastening or hook coupling.

The second printed circuit board 300 may be mounted on the board frame 2400 and be movable with respect to the case 2100 together with the board frame 2400.

The board frame 2400 may be accommodated inside the case 2100. For example, the board frame 2400 may be accommodated inside the inner case 2120. For example, according to a relative position of the board frame 2400 with respect to the case 2100, a portion of the board frame 2400 may penetrate the case opening 2100a and be located outside the case 2100 (e.g., FIG. 9).

As illustrated in FIGS. 7 and 8, the board frame 2400 may be configured to slide with respect to the case 2100. Particularly, the board frame 2400 may be configured to slide between a first frame position 2400A and a second frame position 2400B. For example, the board frame 2400 may move from the first frame position 2400A to the second frame position 2400B by sliding in one direction (+X) of the first direction with respect to the case 2100. Conversely, the board frame 2400 may move from the second frame position 2400B to the first frame position 2400A by sliding in the other direction (-X) of the first direction with respect to the case 2100.

The first frame position 2400A may be defined as the relative position of the board frame 2400 with respect to the case 2100. The first frame position 2400A may be defined as the relative position of the board frame 2400 with respect to the frame guides 2500 and 2600.

Similarly, the second frame position 2400B may be defined as the relative position of the board frame 2400 with respect to the case 2100. The second frame position 2400B may be defined as the relative position of the board frame 2400 with respect to the frame guides 2500 and 2600.

For example, when the board frame 2400 is at the first frame position 2400A, the mounting surface 2410 may be arranged to face the second direction (Y). In other words, at the first frame position 2400A, the mounting surface 2410 may be arranged to face the direction (+Y) toward the case opening 2100a.

For example, when the board frame 2400 is at the second frame position 2400B, the mounting surface 2410 may be arranged to face the second direction Y. In other words, at the second frame position 2400B, the mounting surface 2410 may be arranged to face the direction (+Y) toward the case opening 2100a.

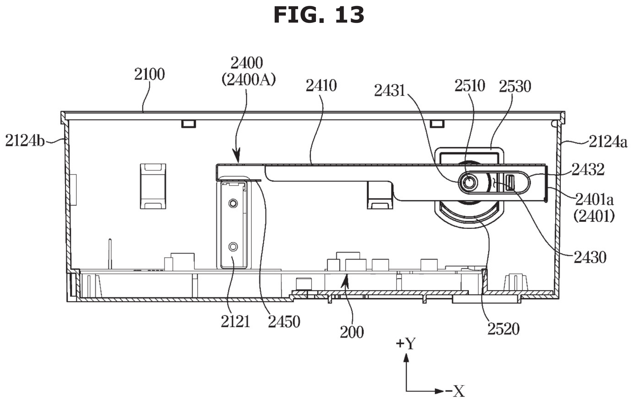

The case 2100 may include a first inner wall 2124a and a second inner wall 2124b (refer to FIG. 13) disposed to face the first inner wall 2124a. For example, the first inner wall 2124a and the second inner wall 2124b may be formed to face each other in the first direction X. For example, the board frame 2400 may be provided to be supported on the first inner wall 2124a when the board frame 2400 is at the first frame position 2400A.

From the first frame position 2400A to the second frame position 2400B, the board frame 2400 may be configured to slide in a direction from the first inner wall 2124a to the second inner wall 2124b (i.e., in a direction away from the first inner wall 2124a in the first direction X). On the other hand, from the second frame position 2400B to the first frame position 2400A, the board frame 2400 may be configured to slide in a direction from the second inner wall 2124b to the first inner wall 2124a (i.e., in a direction close to the first inner wall 2124a in the first direction X).

In order for the board frame 2400 to slide smoothly, a width of the board frame 2400 in the first direction X may be less than a distance between the first inner wall 2124a and the second inner wall 2124b.

As illustrated in FIGS. 8 and 9, the board frame 2400 may be configured to rotate with respect to the case 2100. For example, the board frame 2400 may be configured to rotate between the second frame position 2400B and a third frame position 2400C. For example, the board frame 2400 may rotate from the second frame position 2400B with respect to the case 2100 to a first rotation direction (a direction in which the board frame 2400 rotates from the position of FIG. 8 to the position of FIG. 9), and then move to the third frame position 2400C. On the other hand, the board frame 2400 may rotate from the third frame position 2400C with respect to the case 2100 to a direction opposite to the first rotation direction (a direction in which the board frame 2400 rotates from the position of FIG. 9 to the position of FIG. 8), and then move to the second frame position 2400B.

The third frame position 2400C may be defined as the relative position of the board frame 2400 with respect to the case 2100. The third frame position 2400C may be defined as the relative position of the board frame 2400 with respect to the frame guides 2500 and 2600.

Between the second frame position 2400B and the third frame position 2400C, the board frame 2400 may be configured to rotate about the rotation axis RA1 passing through the inside of the case 2100. Accordingly, the board frame 2400 may be prevented and/or restricted from interfering with the case 2100 while rotating about the rotation axis RA1.

The rotation axis RA1 may extend parallel to the third direction Z. For example, the rotation axis RA1 may extend parallel to the vertical direction of the outdoor unit 10.

For example, when the board frame 2400 is at the third frame position 2400C, the mounting surface 2410 may be arranged to face the first direction X. In other words, at the third frame position 2400C, the mounting surface 2410 may be arranged to face the direction (-X) facing the first inner wall 2124a.

At the first frame position 2400A, the board frame 2400 may be restricted from rotating about the rotation axis RA1 with respect to the case 2100, as will be described in greater detail below. Accordingly, in order to move the board frame 2400 from the first frame position 2400A to the third frame position 2400C, it may be required to perform an operation, in which the board frame 2400 is moved from the first frame position 2400A to the second frame position 2400B, in advance.

When it is assumed that the board frame 2400 is configured to rotate without sliding at the first frame position 2400A of FIG. 7, the second printed circuit board 300, the electronic components mounted thereon, the wires or the components of the board frame 2400 may be interfered with the case 2100, which may cause damage to the components.

When it is assumed that the board frame 2400 is configured to rotate at the second frame position 2400B of FIG. 8 to avoid interference with the case 2100, but the board frame 2400 is not moved to the first frame position 2400A of FIG. 7, the board frame 2400 may not be stably supported by the inner wall of the case 2100.

According to an embodiment of the present disclosure, the board frame 2400 may be supported by the case 2100 at the first frame position 2400A in normal times, and in some cases such as when a worker needs to access the first printed circuit board 200, the board frame 2400 may first be moved from the first frame position 2400A to the second frame position 2400B and then rotated from the second frame position 2400B to the third frame position 2400C. Accordingly, it is possible to prevent and/or reduce the electronic components on the second printed circuit board 300 from being damaged by interference with the case 2100 during the rotation of the board frame 2400, and the worker can easily access the first printed circuit board 200.

In addition, a worker can move the board frame 2400 from the first frame position 2400A to the second frame position 2400B for various purposes other than moving the board frame 2400 to the third frame position 2400C. For example, when a worker needs to inspect, replace, or repair a component located on a portion of the second printed circuit board 300 adjacent to the first inner wall 2124a, the worker can slide the board frame 2400 from the frame position 2400A to the second frame 2400B.

The second control box 2000 may include the frame guides 2500 and 2600. The frame guides 2500 and 2600 may be provided to support the board frame 2400. The frame guides 2500 and 2600 may be provided to guide the movement of the board frame 2400. The sliding movement of the board frame 2400 may be guided by the frame guides 2500 and 2600. The rotational movement of the board frame 2400 may be guided by the frame guides 2500 and 2600. The board frame 2400 may be rotatable about the rotation axis RA1 passing through the frame guides 2500 and 2600.

For example, the control box 2000 may include a first frame guide 2500.

The first frame guide 2500 may be provided to guide the board frame 2400 to slide between the first frame position 2400A relative to the first frame guide 2500 and the second frame position 2400B relative to the first frame guide 2500. The sliding movement of the board frame 2400 may be guided by the first frame guide 2500.

The rotation axis RA1 of the board frame 2400 may be provided to pass through the first frame guide 2500. For example, the board frame 2400 may rotate about the rotation axis RA1 passing through the first frame guide 2500 when the board frame 2400 is positioned at the second frame position 2400B with respect to the first frame guide 2500. The board frame 2400 may be guided by the first frame guide 2500 when the board frame 2400 rotates between the second frame position 2400B and the third frame position 2400C.

The board frame 2400 may be supported by the first frame guide 2500. For example, the first frame guide 2500 may support one side of the board frame 2400 with respect to the third direction Z. The first frame guide 2500 may support one side of the board frame 2400 in the direction of the rotation axis RA1. For example, the first frame guide 2500 may support the upper portion of the board frame 2400.

The first frame guide 2500 may be arranged inside the case 2100. For example, the first frame guide 2500 may be disposed inside the outer case 2110, and at least a portion of the first frame guide 2500 may be disposed inside the inner case 2120. The movement of the board frame 2400 may be guided by a portion of the first frame guide 2500 disposed inside the inner case 2120.

The first frame guide 2500 may be fixed to the case 2100. The first frame guide 2500 may be fixed to one surface of the case 2100 in a direction parallel to the rotation axis RA1 of the board frame 2400. For example, the first frame guide 2500 may be fixed to one surface of the case 2100 perpendicular to the rotation axis RA1 of the board frame 2400. The first frame guide 2500 may be fixed to one surface of the case 2100 in the third direction Z. For example, the first frame guide 2500 may be fixed to the upper surface of the case 2100.

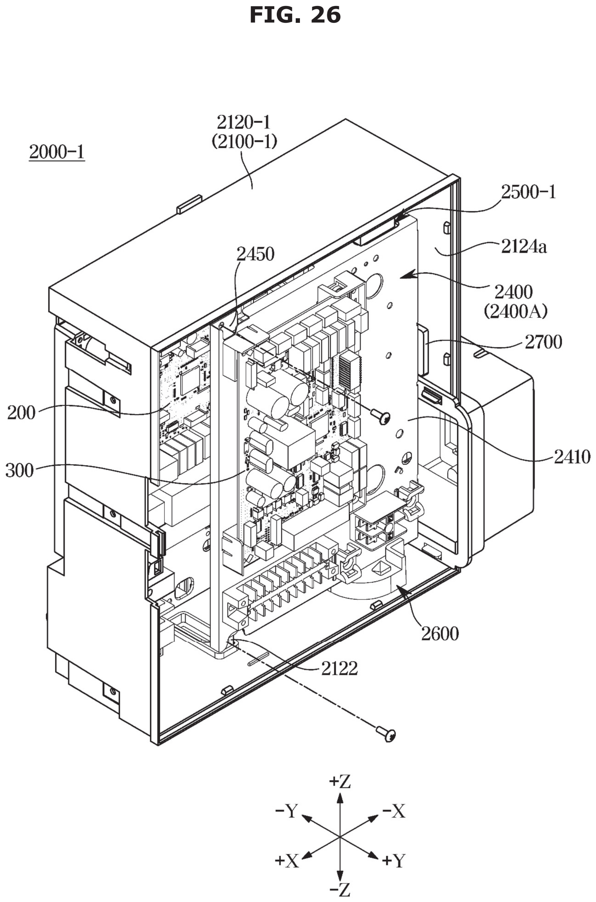

As illustrated in FIG. 6, the first frame guide 2500 may be removably mounted on the inner case 2120. However, the present disclosure is not limited thereto, and the first frame guide 2500 may be formed integrally with the inner case 2120 (refer to a first frame guide 2500-1 of FIG. 26).

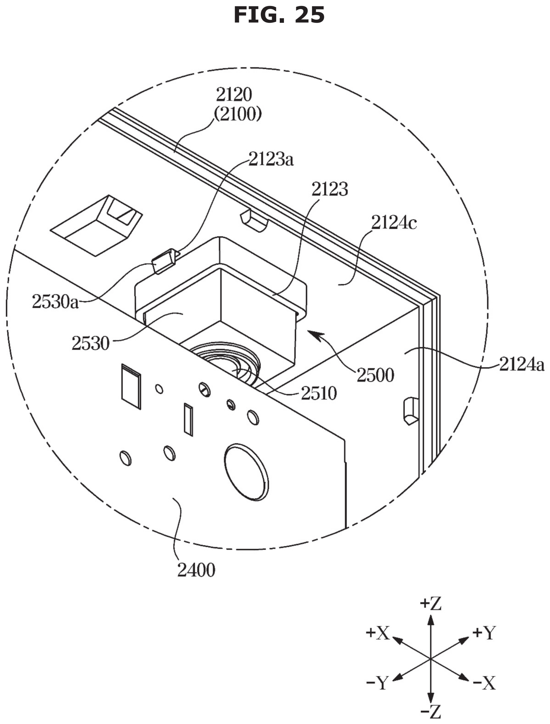

A structure in which the first frame guide 2500 is removably mounted on the inner case 2120 will be described in greater detail below with reference to FIG. 25.

The first frame guide 2500 may be disposed between the first inner wall 2124a and the second inner wall 2124b of the case 2100. Particularly, the first frame guide 2500 may be disposed closer to the first inner wall 2124a than the second inner wall 2124b.

The control box 2000 may include a second frame guide 2600.

The second frame guide 2600 may be provided to guide the board frame 2400 to slide between the first frame position 2400A relative to the second frame guide 2600 and the second frame position 2400B relative to the second frame guide 2600. The sliding movement of the board frame 2400 may be guided by the second frame guide 2600.

The rotation axis RA1 of the board frame 2400 may be provided to pass through the second frame guide 2600. For example, the board frame 2400 may rotate about the rotation axis RA1 passing through the second frame guide 2600 when the board frame 2400 is positioned at the second frame position 2400B with respect to the second frame guide 2600. The board frame 2400 may be guided by the second frame guide 2600 when the board frame 2400 rotates between the second frame position 2400B and the third frame position 2400C.

The board frame 2400 may be supported by the second frame guide 2600. For example, the second frame guide 2600 may support one side of the board frame 2400 with respect to the third direction Z. The second frame guide 2600 may support one side of the board frame 2400 in the direction of the rotation axis RA1. For example, the second frame guide 2600 may support the lower portion of the board frame 2400.

The second frame guide 2600 may be arranged inside the case 2100. For example, the second frame guide 2600 may be disposed inside the inner case 2120.

The second frame guide 2600 may be fixed to the case 2100. The second frame guide 2600 may be fixed to one surface of the case 2100 in the direction parallel to the rotation axis RA1 of the board frame 2400. For example, the second frame guide 2600 may be fixed to one surface of the case 2100 perpendicular to the rotation axis RA1 of the board frame 2400. The second frame guide 2600 may be fixed to one surface of the case 2100 in the third direction Z. For example, the second frame guide 2600 may be fixed to the lower surface of the case 2100.

For example, the second frame guide 2600 may be formed integrally with the inner case 2120. However, the present disclosure is not limited thereto, and in the same or similar manner as the first frame guide 2500, the second frame guide 2600 may be provided as a separate configuration from the inner case 2120 and may be removably mounted on the inner case 2120.

The second frame guide 2600 may be disposed between the first inner wall 2124a and the second inner wall 2124b of the case 2100. For example, the second frame guide 2600 may be disposed closer to the first inner wall 2124a than the second inner wall 2124b.

The board frame 2400 may rotate about the rotation axis RA1 that passes through both the first frame guide 2500 and the second frame guide 2600. Accordingly, the rotation axis RA1 of the board frame 2400 may be provided to pass through the inside of the case 2100. For example, the rotation axis RA1 of the board frame 2400 may be disposed to be closer to the first inner wall 2124a than the second inner wall 2124b of the case 2100.

For example, the first frame guide 2500 and the second frame guide 2600 may be arranged to be spaced apart from each other. For example, the first frame guide 2500 and the second frame guide 2600 may be arranged to face each other along the direction parallel to the rotation axis RA1 of the board frame 2400.

The first frame guide 2500 and the second frame guide 2600 may be arranged side by side in the third direction Z. For example, the first frame guide 2500 and the second frame guide 2600 may be arranged side by side in the vertical direction of the outdoor unit 10.

The first frame guide 2500 may support one of both sides of the board frame 2400 with respect to the third direction Z, and the second frame guide 2600 may support the other side of the board frame 2400 opposite to the one side thereof. With this configuration, the board frame 2400 may be stably supported by the first frame guide 2500 and the second frame guide 2600. Additionally, the movement of the board frame 2400 may be stably supported by the first frame guide 2500 and the second frame guide 2600.

For example, the board frame 2400 may be provided to be separable from the case 2100.

When the first frame guide 2500 is provided to be separable from the case 2100, the board frame 2400 may be separated from the case 2100 after the first frame guide 2500 is separated from the case 2100.

Similarly, when the second frame guide 2600 is provided to be separable from the case 2100, the board frame 2400 may be separated from the case 2100 after the second frame guide 2600 is separated from the case 2100.

Although the first frame guide 2500 and the second frame guide 2600 are not separated from the case 2100, the board frame 2400 may be separated from the first frame guide 2500 and the second frame guide 2600 and then separated from the case 2100.

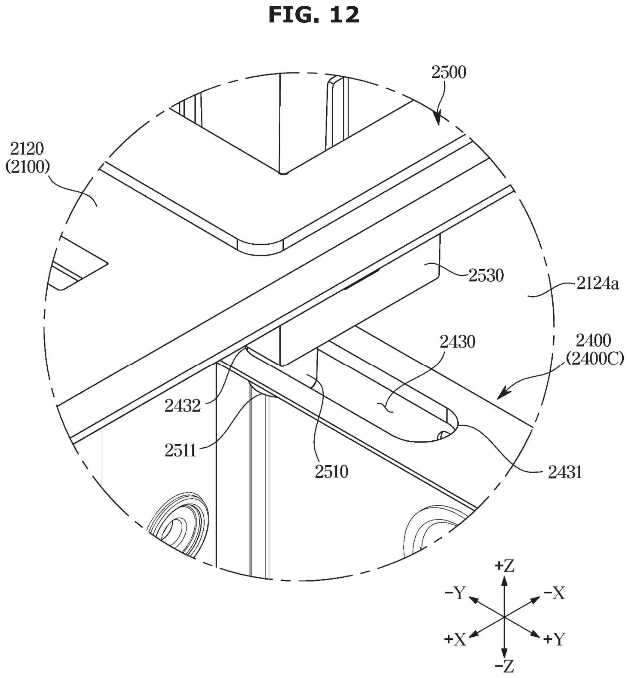

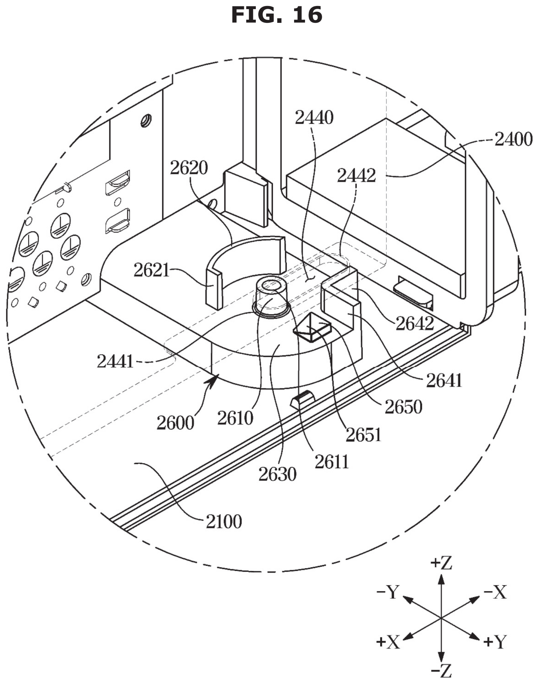

Whether the board frame 2400 is separated from the case 2100 in the state in which the first frame guide 2500 and the second frame guide 2600 are not separated from the case 2100 may be changed according to a separation distance in the third direction Z between the first frame guide 2500 and the second frame guide 2600. For example, whether the board frame 2400 is separated from the case 2100 in the state in which the first frame guide 2500 and the second frame guide 2600 are not separated from the case 2100 may be changed according to a distance between an end 2511 of a first guide shaft 2510 (refer to FIG. 12) provided in the first frame guide 2500, and an end 2611 of a second guide shaft 2610 (refer to FIG. 16) provided in the second frame guide 2600.

When the board frame 2400 is separated from the case 2100 as mentioned above, a worker can perform various tasks on the components within the control box 2000.

On the other hand, the board frame 2400 may be provided not to be separated from the case 2100 unless the first frame guide 2500 or the second frame guide 2600 is separated from the case 2100. In this case, the board frame 2400 may be more firmly supported by the case 2100.

At the first frame position 2400A, the board frame 2400 may be restricted from moving in the second direction Y with respect to the case 2100. At the first frame position 2400A, the board frame 2400 may be restricted from moving in the third direction Z with respect to the case 2100. At the first frame position 2400A, the board frame 2400 may be restricted from rotating with respect to the case 2100.

The control box 2000 may include a locker 2700. The locker 2700 may be provided to limit the movement of the board frame 2400 when the board frame 2400 is located at the first frame position 2400A. The locker 2700 may be provided to allow the movement of the board frame 2400 as the board frame 2400 moves from the first frame position 2400A to the second frame position 2400B.

For example, the locker 2700 may limit the rotation of the board frame 2400 with respect to the case 2100 about the rotation axis RA1 when the board frame 2400 is located at the first frame position 2400A. When the board frame 2400 is positioned at the second frame position 2400B, the locker 2700 may not limit the rotational movement of the board frame 2400 with respect to the case 2100, and thus the board frame 2400 may be configured to rotate between the second frame position 2400B and the third frame position 2400C.

For example, when the board frame 2400 is located at the first frame position 2400A, the sliding movement of the board frame 2400 (e.g., the first direction X) between the first frame position 2400A and the second frame position 2400B, and the movement of the board frame 2400 in the direction (e.g., the second direction Y) perpendicular to an extending direction of the rotation axis RA1 (e.g., the third direction Z) may be limited by the locker 2700.

For example, the locker 2700 may be provided to limit the movement of the board frame 2400 in the extending direction of the rotation axis RA1 (e.g., the third direction Z).

As mentioned above, when the board frame 2400 is located at the first frame position 2400A, the locker 2700 may allow only the sliding movement of the board frame 2400 in the first direction X and may restrict the sliding or rotational movement of the board frame 2400 in other directions.

In other words, when the board frame 2400 is located at the first frame position 2400A, the linear movement of the board frame 2400 in the second direction Y and the third direction Z and the rotational movement of the board frame 2400 about the rotation axis RA1 may be limited by the locker 2700. A movement in which the board frame 2400 slides in one direction (+X) of the first direction from the first frame position 2400A toward the second frame position 2400B separated from the locker 2700 may be allowed.

With this configuration, when the board frame 2400 slides from the first frame position 2400A and is positioned at the second frame position 2400B, the board frame 2400 may rotate with respect to the case 2100. When the board frame 2400 is positioned at the first frame position 2400A, it is possible to prevent or block the rotation of the board frame 2400 caused by unintended causes or worker error.

In addition, because the board frame 2400 is restricted at the first frame position 2400A in normal times, the board frame 2400 may be maintained in the fixed position with respect to the case 2100 and may be stably supported by the case 2100.

The case 2100 may include a first fixing bracket 2121 to which the board frame 2400 is fastened. The first fixing bracket 2121 may be fixed to the case 2100.

The board frame 2400 may include a first fastening portion 2450 provided to be fastened to the first fixing bracket 2121. For example, the first fastening portion 2450 and the first fixing bracket 2121 may be fastened to each other when the board frame 2400 is positioned at the first frame position 2400A.

For example, the first fixing bracket 2121 and the first fastening portion 2450 may be fixed to each other by being in contact with each other in the second direction Y. For example, the first fixing bracket 2121 and the first fastening portion 2450 may be fastened with a screw penetrating in the second direction Y.

For example, the first fixing bracket 2121 may be fixed to the upper surface of the case 2100. For example, the first fastening portion 2450 may be provided on the upper portion of the board frame 2400.

Additionally, the case 2100 may include a second fixing bracket 2122 to which the board frame 2400 is fastened. The second fixing bracket 2122 may be fixed to the case 2100.

The board frame 2400 may include a second fastening portion 2460 provided to be fastened to the second fixing bracket 2122. For example, the second fastening portion 2460 and the second fixing bracket 2122 may be fastened to each other when the board frame 2400 is positioned at the first frame position 2400A.

For example, the second fixing bracket 2122 and the second fastening portion 2460 may be fixed to each other by being in contact with each other in the second direction Y. For example, the second fixing bracket 2122 and the second fastening portion 2460 may be fastened with a screw penetrating in the second direction Y.

For example, the second fixing bracket 2122 may be fixed to the lower surface of the case 2100. For example, the second fastening portion 2460 may be provided in the lower portion of the board frame 2400.

As mentioned above, the board frame 2400 may be fixed to the case 2100 by the first fixing bracket 2121 and the second fixing bracket 2122, and thus the mobility of the board frame 2400 in the first direction X may also be limited as well. When a worker needs to move the board frame 2400 from the first frame position 2400A to the second frame position 2400B, it may be required to firstly release the fastening between the first fastening portion 2450 and the first fixing bracket 2121 and the fastening between the second fastening portion 2460 and the second fixing bracket 2122.

However, the present disclosure is not limited thereto, and the case 2100 may include various components configured to fix the board frame 2400.

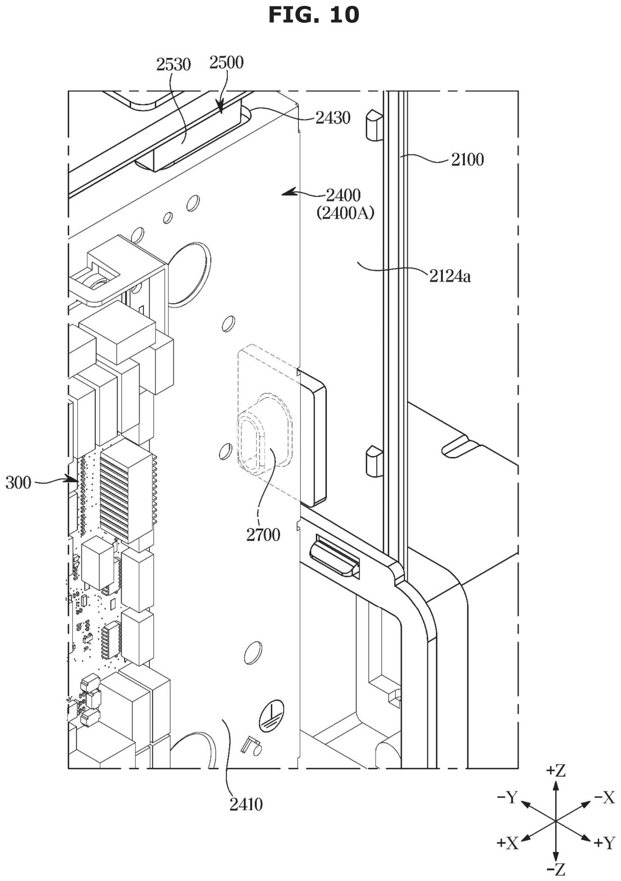

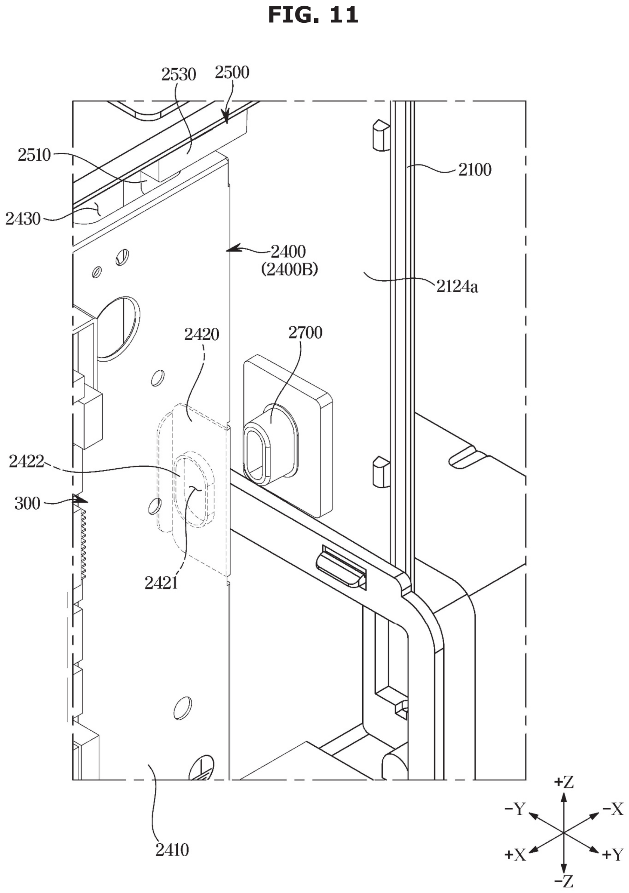

FIG. 10 is an enlarged perspective view illustrating a portion of a configuration when the board frame is in the first frame position in the outdoor unit of the air conditioner according to various embodiments. FIG. 11 is an enlarged perspective view illustrating a portion of the configuration when the board frame is in the second frame position in the outdoor unit of the air conditioner according to various embodiments.

Referring to FIGS. 10 and 11, the movement of the board frame 2400 of the outdoor unit 10 of the air conditioner 1 according to an embodiment of the present disclosure may be restricted or allowed by the locker 2700 according to the position of the board frame 2400.

For example, the locker 2700 may be provided to be locked and coupled to the board frame 2400 when the board frame 2400 is located at the first frame position 2400A.

As illustrated in FIG. 10, the locker 2700 may be locked and coupled to the board frame 2400 in the second direction Y when the board frame 2400 is located at the first frame position 2400A. As shown in FIG. 10, the locker 2700 may be locked and coupled to the board frame 2400 in the third direction Z when the board frame 2400 is located at the first frame position 2400A.

Additionally, the locking connection between the board frame 2400 and the locker 2700 may be released when the board frame 2400 is moved from the first frame position 2400A to the second frame position 2400B.

The locker 2700 may be provided in the case 2100. For example, the locker 2700 may be arranged inside the case 2100. For example, the locker 2700 may be provided on the first inner wall 2124a of the case 2100.

For example, the locker 2700 may be formed integrally with the case 2100. The locker 2700 may be provided in a separate configuration from the case 2100 and then mounted on the case 2100, or may be provided to be detachable from the case 2100.

The locker 2700 may be formed to protrude from the inner wall of the case 2100 toward the board frame 2400. For example, the locker 2700 may be formed to protrude from the first inner wall 2124a toward the board frame 2400. For example, the locker 2700 may be formed to protrude from the inner wall of the case 2100 toward the first direction X.

The board frame 2400 may include a locking hole 2421. The locking hole 2421 may be formed to allow the locker 2700 to be locked and coupled thereto when the board frame 2400 is at the first frame position 2400A.

When the board frame 2400 is at the first frame position 2400A, the locker 2700 may be disposed to penetrate the locking hole 2421 and locked and coupled to the locking hole 2421. When the board frame 2400 moves from the first frame position 2400A to the second frame position 2400B, the locker 2700 may be separated from the locking hole 2421 and the locking connection may be released.

The board frame 2400 may include a support surface 2420 connected to the mounting surface 2410, on which the printed circuit board is mounted, and provided to face a direction different from the direction in which the mounting surface 2410 faces. When the board frame 2400 is positioned at the first position, the support surface 2420 may be supported by the inner wall of the case 2100 or the locker 2700.

For example, the locking hole 2421 may be provided on the support surface 2420. For example, the locking hole 2421 may be formed in a shape that penetrates the support surface 2420.

For example, the locking hole 2421 may be formed to have a size that approximately corresponds to that of the locker 2700.

The board frame 2400 may include a locking hole flange 2422 formed along an edge of the locking hole 2421. The locking hole flange 2422 may extend in one direction from the edge of the locking hole 2421. For example, a direction in which the locking hole flange 2422 extends from the edge of the locking hole 2421 may be a direction parallel to the first direction X when the board frame 2400 is positioned between the first frame position 2400A and the second frame position 2400B. For example, the locking hole flange 2422 may extend from the edge of the locking hole 2412 toward one direction (+X) of the first direction X when the board frame 2400 is positioned between the first frame position 2400A and the second frame position 2400B. One direction (+X) of the first direction X may correspond to a direction in which the board frame 2400 moves from the first frame position 2400A to the second frame position 2400B, and a direction in which the locker 2700 protrudes from the first inner wall 2100a of the case 2100.

For example, the locking hole flange 2422 may be provided on the support surface 2420. The locking hole flange 2422 may be formed to be approximately perpendicular to the support surface 2420.

The locking hole flange 2422 may be provided to be in contact with the locker 2700 when the board frame 2400 is at the first frame position 2400A. When the board frame 2400 is at the first frame position 2400A, the locking hole flange 2422 may be supported by the locker 2700 by being in contact with an outer circumferential surface of the locker 2700.

Accordingly, the board frame 2400 may be more stably supported on the locker 2700 by the locking hole flange 2422 when the board frame 2400 is at the first frame position 2400A.

For example, the locking hole flange 2422 may be formed to have a size that approximately corresponds to that of the locker 2700.

For example, the locker 2700 may be disposed between the first frame guide 2500 and the second frame guide 2600. For example, the locker 2700 may be disposed below (-Z direction) the first frame guide 2500 and may be disposed above (+Z direction) the second frame guide 2600.

For example, the locking hole 2421 may be formed between a first guide hole 2430 and a second guide hole 2440 of the board frame 2400 which will be described in greater detail below. For example, the locking hole 2421 may be disposed below (-Z direction) the first guide hole 2430, and the locking hole 2421 may be disposed above (+Z direction) the second guide hole 2440.

With this configuration, when the board frame 2400 is at the first frame position 2400A, one side of the board frame 2400 in the third direction Z may be supported by the first frame guide 2500, and the other side of the board frame 2400 in the third direction Z may be supported by the second frame guide 2600. A portion of the board frame 2400 between the one side and the other side may be supported by the locker 2700, and thus the board frame 2400 may be more stably supported.

The configuration of the locker 2700 described above is only an example of a configuration provided to restrict the board frame 2400 located at the first frame position 2400A, and the present disclosure is not limited thereto.

A groove including one surface that is closed may be formed in the board frame 2400, and the locker 2700 may be inserted into the groove formed in the board frame 2400 when the board frame 2400 is positioned at the first frame position 2400A.

A hole/groove may be formed on the inner wall of the case 2100, and a protrusion may be formed on the board frame 2400. The protrusion may be inserted into the hole/groove when the board frame 2400 is at the first frame position 2400A.

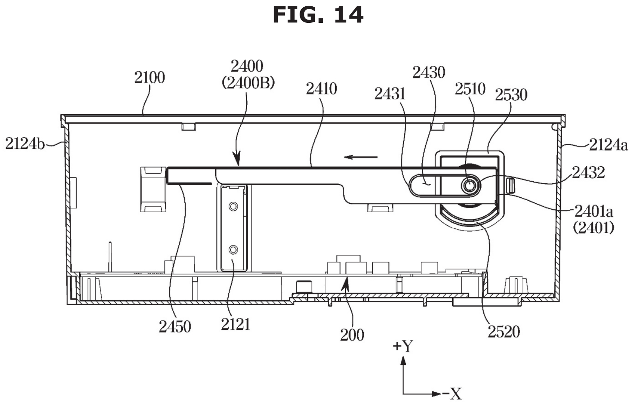

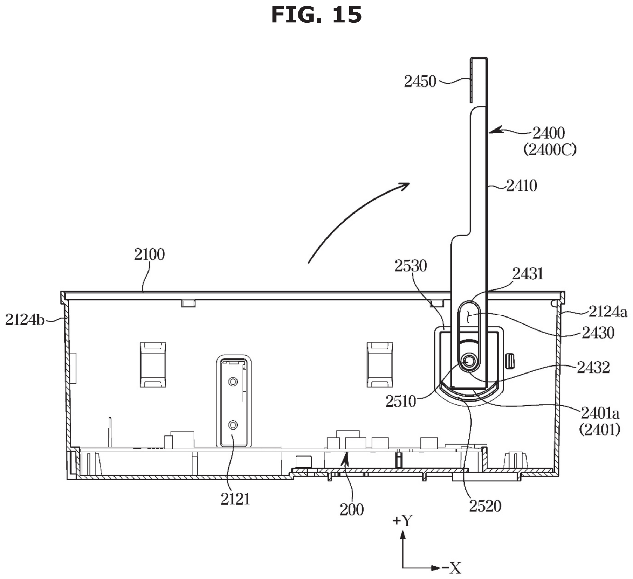

FIG. 12 is an enlarged perspective view illustrating a portion of the configuration when the board frame is in the third frame position in the outdoor unit of the air conditioner according to various embodiments. FIG. 13 is a cross-sectional view illustrating a state in which the board frame is in the first frame position in the outdoor unit of the air conditioner according to various embodiments. FIG. 14 is a cross-sectional view illustrating a state in which the board frame is in the second frame position in the outdoor unit of the air conditioner according to various embodiments. FIG. 15 is a cross-sectional view illustrating a state in which the board frame is in the third frame position in the outdoor unit of the air conditioner according to various embodiments.

Referring to FIGS. 12, 13, 14 and 15 (which may be referred to as FIGS. 12 to 15), the first frame guide 2500 of the outdoor unit 10 of the air conditioner 1 according to an embodiment of the present disclosure may include the first guide shaft 2510. The first guide shaft 2510 may be provided to guide the sliding movement of the board frame 2400 between the first frame position 2400A and the second frame position 2400B. The first guide shaft 2510 may be provided to guide the rotational movement of the board frame 2400 between the second frame position 2400B and the third frame position 2400C.

The first guide shaft 2510 may extend in the direction parallel to the rotation axis RA1. The board frame 2400 may be rotatable about the rotation axis RA1 passing through the first guide shaft 2510.

The board frame 2400 may be provided in such a way that the sliding movement thereof is guided by the first guide shaft 2510 when the board frame 2400 moves between the first frame position 2400A and the second frame position 2400B.

Between the second frame position 2400B and the third frame position 2400C, the board frame 2400 may be provided to rotate relative to the case 2100 with respect to the first guide shaft 2510.

The first guide shaft 2510 may be provided to support the board frame 2400. For example, the first guide shaft 2510 may support one side of the board frame 2400 in the third direction Z. For example, the first guide shaft 2510 may support the upper side of the board frame 2400.

The board frame 2400 may include the first guide hole 2430. When the board frame 2400 slides, the movement of the first guide hole 2430 may be guided by the first guide shaft 2510. The first guide hole 2430 may be supported by the first guide shaft 2510.

For example, the first guide hole 2430 may be formed on one surface, which faces a first guide body 2530, which will be described in greater detail below, of the board frame 2400. For example, the first guide hole 2430 may be formed on the upper surface of the board frame 2400.

The first guide hole 2430 may extend along the direction in which the board frame 2400 slides with respect to the first guide shaft 2510.

For example, the first guide hole 2430 may include a first end 2431, which is one of both ends in the direction in which the board frame 2400 slides with respect to the first guide shaft 2510, and a second end 2432 that is the other end of both ends. The first guide hole 2430 may extend from the first end 2431 to the second end 2432.

As illustrated in FIG. 13, when the board frame 2400 is at the first frame position 2400A, the first guide shaft 2510 may be in contact with the first end 2431 of the first guide hole 2430. As shown in FIG. 14, when the board frame 2400 is at the second frame position 2400B, the first guide shaft 2510 may be in contact with the second end 2432 of the first guide hole 2430. Accordingly, the first frame position 2400A and the second frame position 2400B of the board frame 2400 may be guided.

When the board frame 2400 is at the second frame position 2400B, the board frame 2400 may be rotatable about the first guide shaft 2510 in a state in which the second end 2432 is in contact with the first guide shaft 2510, as shown in FIG. 15. That is, the board frame 2400 may be rotatable between the second frame position 2400B and the third frame position 2400C in the state in which the second end 2432 of the first guide hole 2430 is in contact with the first guide shaft 2510. Accordingly, the board frame 2400 may be configured to stably rotate about the first guide shaft 2510.

The first guide shaft 2510 may be provided to penetrate the first guide hole 2430. For example, the first guide shaft 2510 may be provided to penetrate the first guide hole 2430 in the third direction Z. For example, the end 2511 of the first guide shaft 2510 may be located below (-Z direction) the first guide hole 2430 with respect to the third direction Z.

For example, the first guide shaft 2510 may be formed to have a diameter that approximately corresponds to a width of the first guide hole 2430. Therefore, the first guide shaft 2510 may be in contact with an edge portion of the first guide hole 2430, stably support the board frame 2400, and stably guide the movement of the board frame 2400.

For example, the first guide shaft 2510 may be formed in a substantially cylindrical shape, but the shape thereof is not limited thereto.

The first guide shaft 2510 may be disposed inside the case 2100. Particularly, the first guide shaft 2510 may be disposed inside the inner case 2120.

The first frame guide 2500 may include a first end guide 2520. The first end guide 2520 may be provided to guide the movement of the end 2401 of the board frame 2400 from the inner side of the case 2100.

For example, the first end guide 2520 may guide the movement of the end 2401 of the board frame 2400 when the board frame 2400 rotates between the second frame position 2400B and the third frame position 2400C. When the board frame 2400 rotates about the rotation axis RA1, the end 2401 of the board frame 2400 may be arranged to move along the first end guide 2520. The end 2401 of the board frame 2400 may be one end adjacent to the rotation axis RA1 of the board frame 2400.

For example, when the board frame 2400 rotates between the second frame position 2400B and the third frame position 2400C, the first end guide 2520 may be provided to be in contact with a first portion 2401a positioned on one side of the end 2401 of the board frame 2400 with respect to the third direction Z. For example, the first portion 2401a may be an upper portion of the end 2401 of the board frame 2400.

The first end guide 2520 may be disposed on the inner side of the case 2100 rather than the first guide shaft 2510. That is, the rotation axis RA1 of the board frame 2400 may be provided between the case opening 2100a and the first end guide 2520.

The first end guide 2520 may be formed to have a curved shape. For example, the first end guide 2520 may be formed to have an arc shape approximately centered on the rotation axis RA1. Accordingly, the first end guide 2520 may efficiently guide a rotational movement path of the board frame 2400.

The first frame guide 2500 may include the first guide body 2530. The first guide body 2530 may be provided to be coupled to the case 2100. For example, the first guide body 2530 may be coupled to one side of the case 2100 with respect to the third direction Z. For example, the first guide body 2530 may be coupled to the upper surface of the case 2100.

The first guide shaft 2510 may extend from the first guide body 2530 to the direction parallel to the rotation axis RA1. The first guide shaft 2510 may extend from the first guide body 2530 to a direction penetrating the first guide hole 2430. For example, the first guide shaft 2510 may extend downward (-Z) in the third direction from the first guide body 2530. For example, the first guide shaft 2510 may extend from the first guide body 2530 toward the second guide shaft 2610, which will be described in greater detail below.

The first end guide 2520 may extend from the first guide body 2530. Particularly, the first end guide 2520 may extend from the first guide body 2530 to the direction parallel to the rotation axis RA1. For example, the first end guide 2520 may extend downward (-Z) in the third direction from the first guide body 2530.

As the first guide body 2530 is fixed to the board frame 2400, the board frame 2400 may be more stably supported by the case 2100.

The sliding and rotational movements of the board frame 2400 may be guided by the configuration of the first frame guide 2500 described above with reference to FIGS. 12 to 16.

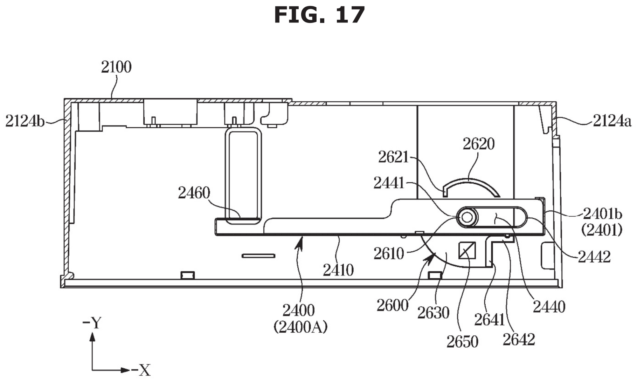

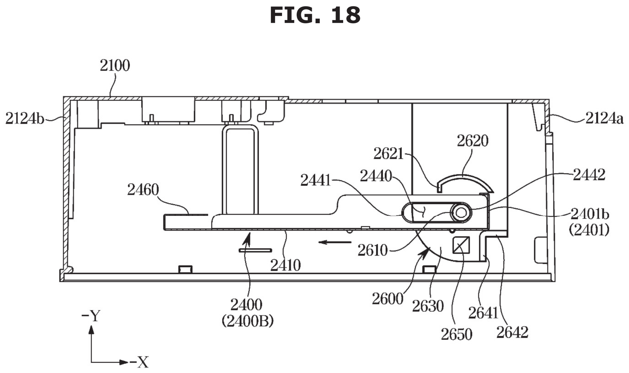

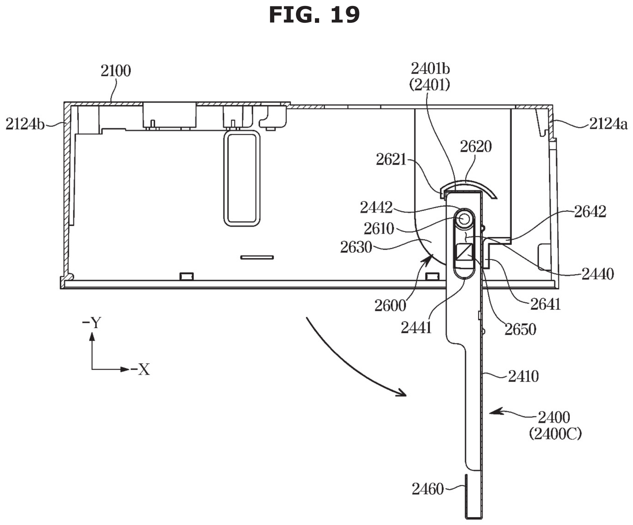

FIG. 16 is an enlarged perspective view illustrating a portion of the configuration when the board frame is in the first frame position in the outdoor unit of the air conditioner according to various embodiments. FIG. 17 is a cross-sectional view illustrating a state in which the board frame is in the first frame position in the outdoor unit of the air conditioner according to various embodiments. FIG. 18 is a cross-sectional view illustrating a state in which the board frame is in the second frame position in the outdoor unit of the air conditioner according to various embodiments. FIG. 19 is a cross-sectional view illustrating a state in which the board frame is in the third frame position in the outdoor unit of the air conditioner according to various embodiments.

Referring to FIGS. 16, 17, 18 and 19 (which may be referred to as FIGS. 16 to 19), the second frame guide 2600 of the outdoor unit 10 of the air conditioner 1 according to an embodiment of the present disclosure may include the second guide shaft 2610. The second guide shaft 2610 may be provided to guide the sliding movement of the board frame 2400 between the first frame position 2400A and the second frame position 2400B. The second guide shaft 2610 may be provided to guide the rotational movement of the board frame 2400 between the second frame position 2400B and the third frame position 2400C.

The second guide shaft 2610 may extend in the direction parallel to the rotation axis RA1. The board frame 2400 may be rotatable about the rotation axis RA1 passing through the second guide shaft 2610.

The board frame 2400 may be provided in such a way that the sliding movement of the board frame 2400 is guided by the second guide shaft 2610 when the board frame 2400 moves between the first frame position 2400A and the second frame position 2400B.

Between the second frame position 2400B and the third frame position 2400C, the board frame 2400 may be provided to rotate relative to the case 2100 with respect to the second guide shaft 2610.

The second guide shaft 2610 may be provided to support the board frame 2400. For example, the second guide shaft 2610 may support one side of the board frame 2400 in the third direction Z. For example, the second guide shaft 2610 may support the lower side of the board frame 2400.

The board frame 2400 may include the second guide hole 2440. When the board frame 2400 slides, the movement of the second guide hole 2440 may be guided by the second guide shaft 2610. The second guide hole 2440 may be supported by the second guide shaft 2610.

For example, the second guide hole 2440 may be formed on one surface, which faces a frame support portion 2630, which will be described in greater detail below, of the board frame 2400. For example, the second guide hole 2440 may be formed on the lower surface of the board frame 2400.

The second guide hole 2440 may extend along the direction in which the board frame 2400 slides with respect to the second guide shaft 2610.

For example, the second guide hole 2440 may include a first end 2441, which is one of both ends in the direction in which the board frame 2400 slides with respect to the second guide shaft 2610, and a second end 2442 that is the other end of both ends. The second guide hole 2440 may extend from the first end 2441 to the second end 2442.

As illustrated in FIG. 17, when the board frame 2400 is at the first frame position 2400A, the second guide shaft 2610 may be in contact with the first end 2441 of the second guide hole 2440. As shown in FIG. 18, when the board frame 2400 is at the second frame position 2400B, the second guide shaft 2610 may be in contact with the second end 2442 of the second guide hole 2440. Accordingly, the first frame position 2400A and the second frame position 2400B of the board frame 2400 may be guided.

When the board frame 2400 is at the second frame position 2400B, the board frame 2400 may be rotatable about the second guide shaft 2610 in a state in which the second end 2442 is in contact with the second guide shaft 2610, as shown in FIG. 19. That is, the board frame 2400 may be rotatable between the second frame position 2400B and the third frame position 2400C in the state in which the second end 2442 of the second guide hole 2440 is in contact with the second guide shaft 2610. Accordingly, the board frame 2400 may be configured to stably rotate about the second guide shaft 2610.

The second guide shaft 2610 may be provided to penetrate the second guide hole 2440. For example, the second guide shaft 2610 may be provided to penetrate the second guide hole 2440 in the third direction Z. For example, the end 2611 of the second guide shaft 2610 may be located above (+Z direction) the second guide hole 2440 with respect to the third direction Z.

For example, the second guide shaft 2610 may be formed to have a diameter that approximately corresponds to a width of the second guide hole 2440. Therefore, the second guide shaft 2610 may be in contact with an edge portion of the second guide hole 2440, stably support the board frame 2400, and stably guide the movement of the board frame 2400.

For example, the second guide shaft 2610 may be formed in a substantially cylindrical shape, but the shape thereof is not limited thereto.

The second guide shaft 2610 may be disposed inside the case 2100. Particularly, the second guide shaft 2610 may be disposed inside the inner case 2120.

The second frame guide 2600 may include a second end guide 2620. The second end guide 2620 may be provided to guide the movement of the end 2401 of the board frame 2400 from the inner side of the case 2100.

For example, the second end guide 2620 may guide the movement of the end 2401 of the board frame 2400 when the board frame 2400 rotates between the second frame position 2400B and the third frame position 2400C. When the board frame 2400 rotates about the rotation axis RA1, the end 2401 of the board frame 2400 may be arranged to move along the second end guide 2620. The end 2401 of the board frame 2400 may be one end adjacent to the rotation axis RA1 of the board frame 2400.

For example, when the board frame 2400 rotates between the second frame position 2400B and the third frame position 2400C, the second end guide 2620 may be provided to be in contact with a second portion 2401b positioned on one side of the end 2401 of the board frame 2400 with respect to the third direction Z. For example, the second portion 2401b may be a lower portion of the end 2401 of the board frame 2400.

The second end guide 2620 may be disposed on the inner side of the case 2100 rather than the second guide shaft 2610. That is, the rotation axis RA1 of the board frame 2400 may be provided between the case opening 2100a and the second end guide 2620.

The second end guide 2620 may be formed to have a curved shape. For example, the second end guide 2620 may be formed to have an arc shape approximately centered on the rotation axis RA1. Accordingly, the second end guide 2620 may efficiently guide a rotational movement path of the board frame 2400.

The second frame guide 2600 may include a first block portion 2621. When the board frame 2400 is located at the third frame position 2400C, the first block portion 2621 may prevent and/or block the board frame 2400 from rotating from the third frame position 2400C to the first rotation direction (counterclockwise direction based on FIG. 19). The first block portion 2621 may be provided to be in contact with the board frame 2400 at the third frame position 2400C. For example, the first block portion 2621 may be provided to be in contact with the board frame 2400 at the third frame position 2400C in the first direction X.

For example, the first block portion 2621 may be connected to the second end guide 2620. For example, the first block portion 2621 may be connected to one end of the second end guide 2620 in the first direction X. For example, the first block portion 2621 may be provided on one side of the second end guide 2620 with respect to one direction (+X direction) in which the board frame 2400 moves from the first frame position 2400A to the second frame position 2400B in the first direction X. Further, the first block portion 2621 may be formed integrally with the second end guide 2620.

For example, the first block portion 2621 may extend parallel to the second direction Y. For example, the first block portion 2621 may extend from one end of the second end guide 2620 toward one direction (+Y direction) facing the second guide shaft 2610 in the second direction Y.

As illustrated in FIG. 17, the first block portion 2621 may prevent or block the board frame 2400 from rotating toward the second rotation direction (clockwise direction based on FIG. 17) when the board frame 2400 is at the first frame position 2400A. As illustrated in FIG. 17, the other end of the second end guide 2620, which is opposite to the first block portion 2621, may be provided to prevent or restrict the board frame 2400 from rotating toward the first rotation direction (counterclockwise direction based on FIG. 17) when the board frame 2400 is at the first frame position 2400A. Therefore, even when the locker 2700 is not separately provided in the outdoor unit 10 of the air conditioner 1 according to an embodiment, the rotational movement of the board frame 2400 may be restricted at the first frame position 2400A.

The second frame guide 2600 may include a second block portion 2641. When the board frame 2400 is located at the third frame position 2400C, the second block portion 2641 may prevent or block the board frame 2400 from rotating from the third frame position 2400C to the first rotation direction (counterclockwise direction based on FIG. 19). The second block portion 2622 may be provided to be in contact with the board frame 2400 at the third frame position 2400C. For example, the second block portion 2622 may be provided to be in contact with the board frame 2400 at the third frame position 2400C in the first direction X.

For example, the second block portion 2641 may be disposed closer to the case opening 2100a than the first block 2621. For example, the second guide shaft 2610 may be disposed between the first block 2621 and the second block 2641.

For example, the second block portion 2641 may extend parallel to the second direction Y.

As mentioned above, the second frame guide 2600 may guide the rotational movement of the board frame 2400 by including the first block portion 2621 and the second block portion 2641.

The second frame guide 2600 may include a third block portion 2642. When the board frame 2400 is located at the first frame position 2400A, the third block portion 2642 may prevent or block the board frame 2400 from rotating to the second rotation direction (clockwise direction based on FIG. 17). The third block portion 2642 may be provided to be in contact with the board frame 2400 at the first frame position 2400A. For example, the third block portion 2642 may be provided to be in contact with the board frame 2400 at the first frame position 2400A in the second direction Y.

For example, the third block portion 2642 may extend in the first direction X.

At the first frame position 2400A, the board frame 2400 may be prevented or restricted from moving in the second direction Y by the first block portion 2621 and the third block portion 2642.

For example, the second block portion 2641 and the third block portion 2642 may be connected to each other. For example, the second block portion 2641 may extend from one end of the third block portion 2642 toward one direction (+Y direction) toward the case opening 2100a in the second direction Y. For example, the third block portion 2642 may extend from one end of the second block portion 2641 toward one direction (-X direction) toward the first inner wall 2124a of the case 2100 in the first direction X. Further, the second block portion 2642 and the third block portion 2643 may be formed integrally with each other.

The second frame guide 2600 may include an interference protrusion 2650.

When the board frame 2400 is located at the third frame position 2400C, the interference protrusion 2650 may prevent or block the board frame 2400 from rotating from the third frame position 2400C to the second rotation direction (clockwise direction based on FIG. 19). The interference protrusion 2650 may be provided to interfere with the board frame 2400 when the board frame 2400 is located at the third frame position 2400C.

For example, the interference protrusion 2650 may be provided to be locked and coupled to the second guide hole 2440 when the board frame 2400 is located at the third frame position 2400C. The interference protrusion 2650 may be provided to be inserted into the second guide hole 2440 when the board frame 2400 is located at the third frame position 2400C.

For example, the interference protrusion 2650 may be located in a direction (+Y direction) closer to the case opening 2100a than the second guide shaft 2610.

A structure of the interference protrusion 2650 will be described in greater detail below.

The second frame guide 2600 may include the frame support portion 2630. The frame support portion 2630 may be provided to support one surface of the board frame 2400. For example, the frame supporter portion 2630 may support one surface of the board frame 2400 with respect to the third direction Z. For example, the frame support portion 2630 may support the lower surface of the board frame 2400.

The frame support portion 2630 may be provided inside the case 2100. For example, the frame support portion 2630 may be provided on one side of the case 2100 with respect to the third direction Z. For example, the frame support portion 2630 may be provided in the lower portion of the case 2100.

The second guide shaft 2610 may extend from the frame support portion 2630 to the direction parallel to the rotation axis RA1. The second guide shaft 2610 may extend from the frame support portion 2630 to the direction penetrating the second guide hole 2440. For example, the second guide shaft 2610 may extend upward (+Z) in the third direction from the frame support portion 2630. For example, the second guide shaft 2610 may extend from the frame support portion 2630 toward the first guide shaft 2510.

The second end guide 2620 may extend from the frame support portion 2630. Particularly, the second end guide 2620 may extend from the frame support portion 2630 to the direction parallel to the rotation axis RA1. For example, the second end guide 2620 may extend upward (+Z) in the third direction from the frame support portion 2630.

The first block portion 2621 may extend from the frame support portion 2630. For example, the first block portion 2621 may extend from the frame support portion 2630 to the third direction Z. For example, the first block portion 2621 may extend upward (+Z) in the third direction from the frame support portion 2630.

The second block 2641 may extend from the frame support portion 2630. Particularly, the second block portion 2641 may extend from the frame support portion 2630 in the third direction Z. For example, the second block portion 2641 may extend upward (+Z) in the third direction from the frame support portion 2630.

The third block portion 2642 may extend from the frame support portion 2630. Particularly, the third block portion 2642 may extend from the frame support portion 2630 in the third direction Z. For example, the third block portion 2642 may extend upward (+Z) in the third direction from the frame support portion 2630.

The interference protrusion 2650 may protrude from the frame support portion 2630. For example, the interference protrusion 2650 may protrude from the frame support portion 2630 to the third direction Z. For example, the interference protrusion 2650 may protrude upward (+Z direction) from the frame support portion 2630.

For example, the frame support portion 2630 may be formed integrally with the inner case 2120, but is not limited thereto.

The sliding and rotational movements of the board frame 2400 may be guided by the configuration of the second frame guide 2600 described above with reference to FIGS. 16 to 19.

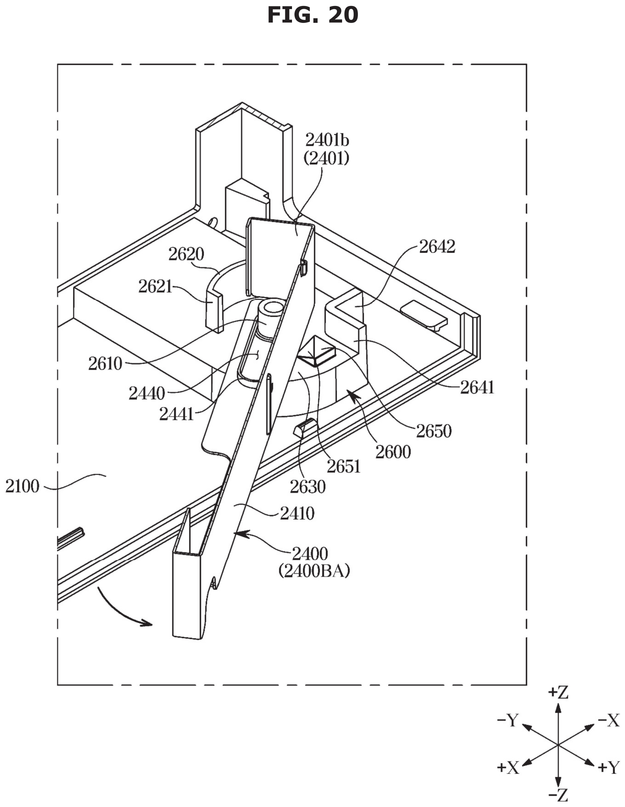

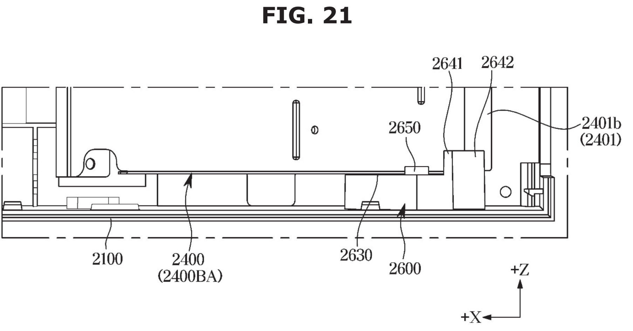

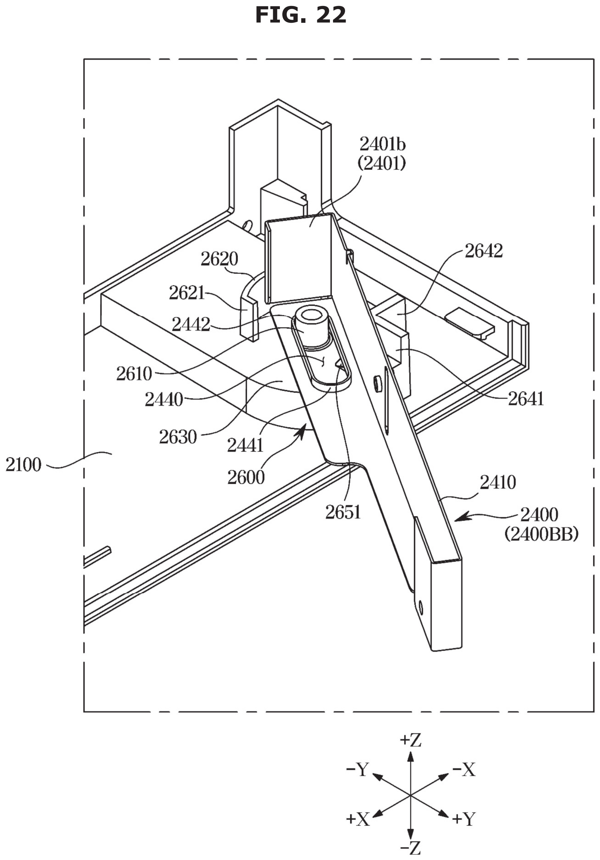

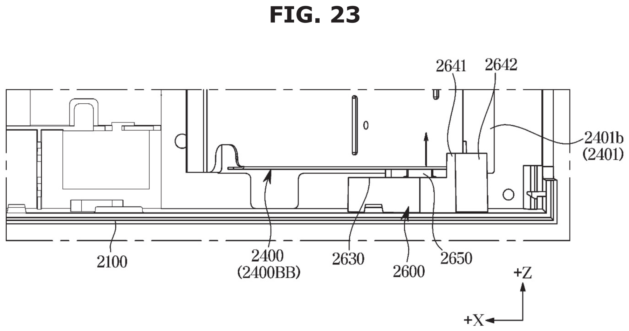

FIG. 20 is a perspective view illustrating a state in which the board frame is rotating from the second frame position to the third frame position in the outdoor unit of the air conditioner according to various embodiments. FIG. 21 is a cross-sectional view illustrating a state in which the board frame is rotating from the second frame position to the third frame position in the outdoor unit of the air conditioner according to various embodiments. FIG. 22 is a perspective view illustrating a state in which the board frame is rotating from the second frame position to the third frame position in the outdoor unit of the air conditioner according to various embodiments. FIG. 23 is a cross-sectional view illustrating a state in which the board frame is rotating from the second frame position to the third frame position in the outdoor unit of the air conditioner according to various embodiments.

Referring to FIGS. 20, 21, 22 and 23 (which may be referred to as FIGS. 20 to 23), the interference protrusion 2650 disposed on the second frame guide 2600 of the outdoor unit 10 of the air conditioner 1 according to an embodiment of the present disclosure may guide the movement of the board frame 2400 to allow the board frame 2400 to cross the interference protrusion 2650 and reach the third frame position 2400C when the board frame 2400 rotates from the second frame position 2400B to the third frame position 2400C.

For example, the board frame 2400 may be provided to be linearly movable along the direction of the rotation axis RA1 when the board frame 2400 is positioned between the second frame position 2400B and the third frame position 2400C.

The interference protrusion 2650 may guide the board frame 2400 to move from the frame support portion 2630 toward a direction away from the rotation axis RA1 when the board frame 2400 reaches the position of the interference protrusion 2650 while the board frame 2400 rotates in the first rotation direction from the second frame position 2400B toward the third frame position 2400C.

For example, the interference protrusion 2650 may include a chamfer portion 2651. The chamfer portion 2651 may be formed to be inclined with respect to the frame support portion 2630.

The chamfer portion 2651 may be provided on one side of the interference protrusion 2650 facing the board frame 2400 that is moving from the second frame position 2400B toward the third frame position 2400C.

The chamfer portion 2651 may guide the board frame 2400 to move toward the direction away from the frame support portion 2630 when the board frame 2400 moves in the first rotation direction from intermediate positions 2400BA and 2400BB between the second frame position 2400B and the third frame position 2400C.

Referring to FIGS. 20 and 21, while the board frame 2400 rotates in the first rotation direction from the second frame position 2400B to a first intermediate position 2400BA, which is the position in FIGS. 20 and 21, the lower surface of the board frame 2400 may be supported by the frame support portion 2630 and the board frame 2400 may rotate.

Referring to FIGS. 22 and 23, as the board frame 2400 further rotates in the first rotation direction from the first intermediate position 2400BA toward a second intermediate position 2400BB, which is the position in FIGS. 20 and 21, the board frame 2400 may be guided by the chamfer portion 2651 and may rise upward (+Z direction).

When the board frame 2400 further rotates in the first rotation direction from the second intermediate position 2400BB and reaches the third frame position 2400C, the board frame 2400 may descend downward (-Z direction), and the interference protrusion 2650 may be inserted into the second guide hole 2440 and locked and coupled to the board frame 2400.

With this configuration, the board frame 2400 may rotate smoothly in the first rotation direction from the second frame position 2400B to the third frame position 2400C despite of the interference protrusion 2650 provided between the second frame position 2400B and the third frame position 2400C.

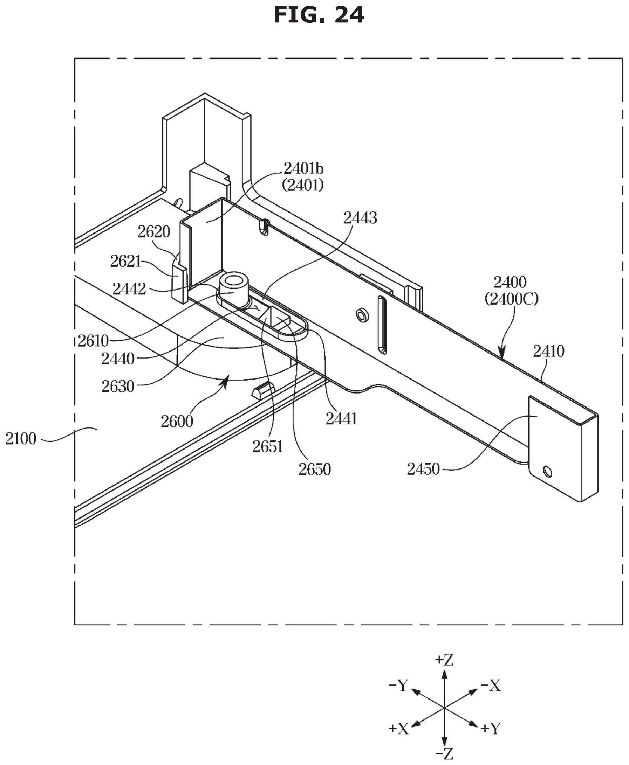

FIG. 24 is a perspective view illustrating a state in which the board frame is in the third frame position in the outdoor unit of the air conditioner according to various embodiments.

Referring to FIG. 24, when the board frame 2400 of the outdoor unit 10 of the air conditioner 1 according to an embodiment of the present disclosure is located at the third frame position 2400C, the board frame 2400 may be interfered by the interference protrusion 2650 and thus the board frame 2400 may be prevented or restricted from rotating in the second rotation direction toward the second frame position 2400B.

Particularly, the interference protrusion 2650 may be inserted into the second guide hole 2440 of the board frame 2400 and interfere with the edge of the second guide hole 2440.

For example, the interference protrusion 2560 may be formed to have a width corresponding to the width of the second guide hole 2440.

For example, the board frame 2400 may include a guide hole flange 2443 provided along the edge of the second guide hole 2440.

The guide hole flange 2443 may extend in one direction from the edge of the second guide hole 2440. For example, the direction in which the guide hole flange 2443 extends from the edge of the second guide hole 2440 may be parallel to the direction in which the interference protrusion 2650 protrudes from the frame support portion 2630. Particularly, the guide hole flange 2443 may extend from the edge of the second guide hole 2440 toward one direction (+Z) of the third direction Z.

For example, the guide hole flange 2443 may be provided on one surface of the board frame 2400 facing the frame support portion 2630. The guide hole flange 2443 may be formed to be substantially perpendicular to one surface of the board frame 2400 facing the frame support portion 2630.

The guide hole flange 2443 may be provided to be in contact with the interference protrusion 2650 when the board frame 2400 is at the third frame position 2400C. For example, when the board frame 2400 is at the third frame position 2400C, the guide hole flange 2443 may be in contact with the interference protrusion 2650 with respect to the first direction X.

Accordingly, the board frame 2400 may be stably fixed by the guide hole flange 2443 when the board frame 2400 is at the third frame position 2400C, and while a worker is working on the first printed circuit board 200, the guide hole flange 2443 may prevent or restrict the board frame 2400 from shaking unnecessarily.

FIG. 25 is an enlarged perspective view illustrating a portion of the configuration of the outdoor unit of the air conditioner according to various embodiments.

Referring to FIG. 25, in the outdoor unit 10 of the air conditioner 1 according to an embodiment of the present disclosure, the first frame guide 2500 may be removably mounted to the case 2100.

For example, the first frame guide 2500 may be removably mounted on the inner case 2120. For example, the first frame guide 2500 may be provided on an upper surface 2124c of the inner case 2120.

For example, a coupling hook 2530a may be provided on the first guide body 2530 of the first frame guide 2500. For example, the coupling hook 2530a may be provided to be elastically deformable by an external force.

For example, a hook groove 2123a may be formed in the guide mounting portion 2123 of the inner case 2120 to allow the coupling hook 2530a to be locked and coupled thereto. For example, the hook groove 2123a may be formed on the upper surface 2124c of the inner case 2120.

When the coupling hook 2530a is pressed while the first frame guide 2500 is coupled to the inner case 2120, the locking connection between the coupling hook 2530a and the hook groove 2123a may be released. Thereafter, when a worker lifts the first guide body 2530 upward (+Z direction), the first frame guide 2500 may be separated from the inner case 2120.

With this configuration, the board frame 2400 may be firmly supported when the first frame guide 2500 is mounted on the case 2100. Further, when there is need to separate the board frame 2400 from the case 2100, the board frame 2400 may also be separated from the case 2100 by separating the first frame guide 2500.

FIG. 26 is a perspective view illustrating a portion of a configuration of a second control box of the outdoor unit of the air conditioner according to various embodiments.

As for describing a control box 2000-1 provided in the outdoor unit 10 of the air conditioner 1 according to an embodiment of the present disclosure with reference to FIG. 26, the same reference numeral may be assigned to a configuration the same as or similar to the configuration described with reference to FIGS. 1 to 25 and a description thereof may not be repeated here.

Referring to FIG. 26, the control box 2000-1 of the outdoor unit 10 of the air conditioner 1 according to an embodiment of the present disclosure may include a case 2100-1. For example, in the same or similar manner as the embodiments of FIGS. 1 to 25, the case 2100-1 may include an inner case 2120-1 and an outer case.

The control box 2000-1 may include a first frame guide 2500-1. The first frame guide 2500-1 may be formed integrally with the inner case 2120-1.

Accordingly, the total number of components of the product may be reduced, the manufacturing cost may be reduced, and the manufacturing process may be simplified.

A configuration of the first frame guide 2500-1 according to the embodiment of FIG. 26 corresponds to the configuration of the first frame guide 2500 described in the embodiment of FIGS. 1 to 25, and thus a description thereof may not be repeated here.

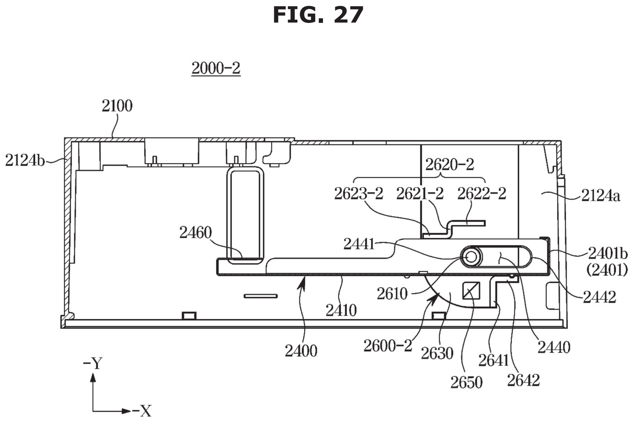

FIG. 27 is a cross-sectional view illustrating a portion of a configuration of a second control box of the outdoor unit of the air conditioner according to various embodiments.

As for describing a control box 2000-2 provided in the outdoor unit 10 of the air conditioner 1 according to an embodiment of the present disclosure with reference to FIG. 27, the same reference numeral may be assigned to a configuration the same as or similar to the configuration described with reference to FIGS. 1 to 25 and a description thereof may not be repeated here.

Referring to FIG. 27, the control box 2000-2 of the outdoor unit 10 of the air conditioner 1 according to an embodiment of the present disclosure may include a second frame guide 2600-2.

The second frame guide 2600-2 may include a guide rib 2620-2.

For example, the guide rib 2620-2 may include a slide guide 2623-2 provided to guide the sliding movement of the board frame 2400. The slide guide 2623-2 may be provided parallel to the sliding direction of the board frame 2400.

For example, the guide rib 2620-2 may include a first block portion 2621-2 provided to prevent or restrict the board frame 2400 from further rotating in the first rotation direction (counterclockwise direction based on FIG. 27) when the board frame 2400 is located at the third frame position 2400C. For example, the first block portion 2621-2 may extend in the second direction Y. For example, the first block portion 2621-2 may be in contact with the board frame 2400 at the third frame position 2400C in the first direction X.

For example, the guide rib 2620-2 may include an end contact portion 2622-2. The end contact portion 2622-2 may be provided to be in contact with the second portion 2401b of the end 2401 of the board frame 2400 when the board frame 2400 is located at the third frame position 2400C. When the board frame 2400 is located at the third frame position 2400C, the end contact portion 2622-2 may be in contact with the second portion 2401b of the end 2401 of the board frame 2400 in the second direction Y so as to prevent or restrict the board frame 2400 from moving in one direction (-Y direction) of the second direction Y.

For example, each component of the guide rib 2620-2, such as the slide guide portion 2623-2, the first block portion 2621-2, and the end contact portion 2622-2, may be formed integrally with each other.

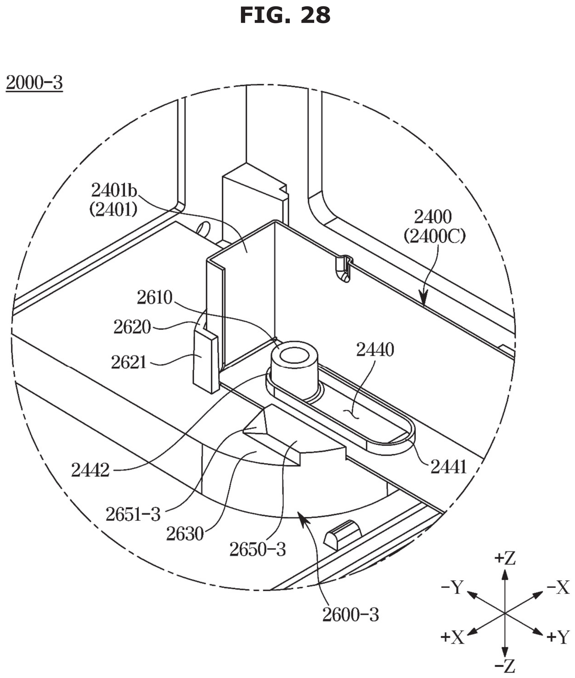

FIG. 28 is an enlarged perspective view illustrating a portion of a configuration when a board frame is in a third frame position in a second control box of the outdoor unit of the air conditioner according to various embodiments.

As for describing a control box 2000-3 provided in the outdoor unit 10 of the air conditioner 1 according to an embodiment of the present disclosure with reference to FIG. 28, the same reference numeral may be assigned to a configuration the same as or similar to the configuration described with reference to FIGS. 1 to 25 and a description thereof may not be repeated here.

Referring to FIG. 28, the control box 2000-3 of the outdoor unit 10 of the air conditioner 1 according to an embodiment of the present disclosure may include a second frame guide 2600-3.

The second frame guide 2600-3 may include an interference protrusion 2650-3 provided to prevent or block the board frame 2400 from further rotating in the second rotation direction toward the second frame position 2400B when the board frame 2400 is located at the third frame position 2400C.

The interference protrusion 2650-3 may be not inserted into the guide hole 2440, but be in contact with one side of the board frame 2400 to prevent or restrict the rotation of the board frame 2400.

The interference protrusion 2650-3 may include a chamfer portion 2651-3. A description of the chamfer portion 2651-3 may not be repeated here because the description of the chamber portion 2651-3 corresponds to the description of the chamfer portion 2651 described with reference to FIGS. 20 to 23.

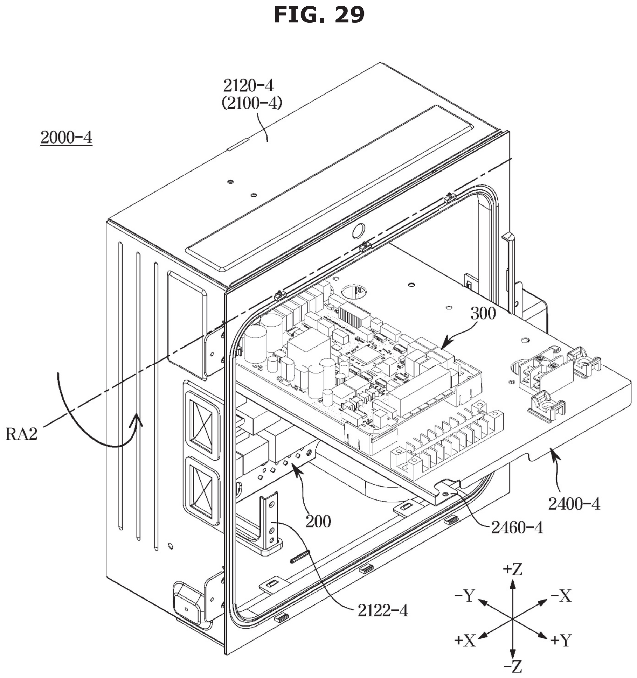

FIG. 29 is a perspective view illustrating a portion of a configuration of a second control box of the outdoor unit of the air conditioner according to various embodiments.

As for describing a control box 2000-4 provided in the outdoor unit 10 of the air conditioner 1 according to an embodiment of the present disclosure with reference to FIG. 29, the same reference numeral may be assigned to a configuration the same as or similar to the configuration described with reference to FIGS. 1 to 25 and a description thereof may not be repeated here.

Referring to FIG. 29, the outdoor unit 10 of the air conditioner 1 according to an embodiment of the present disclosure may include the control box 2000-4.

The control box 2000-4 according to an embodiment may include a board frame 2400-4 configured to rotate relative to a case 2100-4 with respect to a rotation axis RA2 parallel to the horizontal direction (e.g., the X direction as shown in the drawing).

For example, the board frame 2400-4 may slide in the third direction Z with respect to the case 2100-4 and then be rotatable relative the case 2100-4 with respect to the rotation axis RA2 parallel to the first direction X.

An inner case 2120-4 of the case 2100-4 may be provided with components such as a frame guide provided to allow the board frame 2400-4 to slide and to rotate about the rotation axis RA2.

For example, the board frame 2400-4 may include a fastening portion 2460-4 provided to be fastened by a fixing bracket 2122-4 fixed to the case 2100-4, and thus the board frame 2400-4 may be fixed more stably to the case 2100-4.

In the above, an example embodiment, in which the structure of the first frame guide and the structure of the second frame guide are different in the frame guide included in the outdoor unit of the air conditioner according to the present disclosure, is described with reference to FIGS. 7 to 29. However, the present disclosure is not limited thereto.

For example, a portion of the structure of the first frame guide may be applied to the second frame guide, and a portion of the structure of the second frame guide may be applied to the first frame guide. The structure of the first frame and the structure of the second frame may be applied opposite to the examples described in FIGS. 1 to 29.

In the above, the control box included in the outdoor unit of the air conditioner according to the present disclosure is described based on the second control box 2000, 2000-1, 2000-2, 2000-3, or 2000-4 of the outdoor unit 10 of the air conditioner 1 according to an embodiment, with reference to FIGS. 7 to 29. However, the configuration of the second control box 2000, 2000-1, 2000-2, 2000-3, or 2000-4 may be applied to the first control box 1000 according to an embodiment.

Further, the configuration of the second control box 2000, 2000-1, 2000-2, 2000-3, or 2000-4 may be applied to a control box provided in various types of devices, as well as the outdoor unit 10 of the air conditioner 1 according to an embodiment of the present disclosure.

An outdoor unit of the air conditioner according to an example embodiment may include: a case , a board frame configured to move relative to the case and on which the printed circuit board is mounted, and the frame guides disposed inside the case and configured to support the board frame. The board frame may be configured to slide between a first frame position with respect to the frame guide and a second frame position with respect to the frame guide, and configured to allow a sliding movement of the board frame to be guided by the frame guide. In response to the board frame being at the second frame position with respect to the frame guide, the board frame may be configured to rotate about the rotation axis passing through the frame guide.

The case may include a first inner wall and a second inner wall disposed to face the first inner wall. The board frame may be configured to slide in a direction, from the first inner wall to the second inner wall, from the first frame position to the second frame position.

The outdoor unit of the air conditioner may further include: a locker disposed inside the case. In response to the board frame being at the first frame position with respect to the frame guide, the locker may be configured to be locked and coupled to the board frame and to block the board frame from rotating about the rotation axis. In response to the board frame moving from the first frame position to the second frame position with respect to the frame guide, the locker may be configured to release the locking connection between the board frame.

In response to the board frame being at the first frame position with respect to the frame guide, the locker may be configured to block the board frame from moving in a direction perpendicular to a sliding direction between the first frame position with respect to the frame guide and the second frame position and a direction in which the rotation axis extends.

The locker may protrude from the inner wall of the case toward the board frame. The board frame may further include a locking hole configured to allow the locker to be locked and coupled thereto in response to the board frame being at the first frame position with respect to the frame guide.

The board frame may include a mounting surface on which the printed circuit board is mounted, and a support surface connected to the mounting surface and facing a direction different from a direction in which the mounting surface faces. The locking hole may have a shape configured to penetrate the support surface.

The frame guide may include guide shafts extending in a direction parallel to the rotation axis. The sliding movement of the board frame may be guided by the guide shaft in response to the board frame moving between the first frame position with respect to the frame guide and the second frame position with respect to the frame guide. The board frame may be configured to rotate about the guide shaft in response to the board frame rotating at the second frame position with respect to the frame guide.

The board frame may include guide holes through which the guide shaft passes. The guide hole may extend along the direction in which the board frame slides with respect to the guide shaft.

One end of both ends of the guide hole in a direction in which the board frame slides with respect to the guide shaft, may be provided to be in contact with the guide shaft in response to the board frame being at the first frame position. Another end of the guide hole may be provided to be in contact with the guide shaft in response to the board frame being at the second frame position.

The frame guide may include an end guide configured to guide the movement of one end of the board frame inside the case. One end of the board frame may be provided to move along the end guide in response to the board frame rotating about the rotation axis.

The board frame may be configured to rotate in the first rotation direction from the second frame position with respect to the frame guide toward a third frame position. The frame guide may further include a block portion configured to be in contact with the board frame to block the board frame from rotating from the third frame position to the first rotation direction in response to the board frame being at the third frame position.

The board frame may be configured to rotate in the first rotation direction from the second frame position with respect to the frame guide toward the third frame position. The frame guide may include a frame support portion configured to support one surface of the board frame, and an interference protrusion protruding from the frame support portion. The interference protrusion may be configured to interfere with the board frame to inhibit the board frame from rotating in the second rotation direction opposite to the first rotation direction from the third frame position in response to the board frame being at the third frame position.

The board frame may include a guide hole formed on one surface facing the frame support portion. The interference protrusion may be configured to be inserted into the guide hole in response to the board frame being at the third frame position.

The board frame may be configured to move linearly along the direction of the rotation axis in response to the board frame being positioned between the second frame position and the third frame position. The interference protrusion may include a chamfer portion inclined with respect to the frame support portion and configured to guide the board frame to move toward the direction away from the frame support portion in response to the board frame moving in the first rotation direction from the intermediate position between the second frame position and the third frame position.

The frame guide may include a first frame guide and a second frame guide disposed to be spaced apart from the first frame guide. The first frame guide and the second frame guide may be arranged to face each other along the direction parallel to the rotation axis of the board frame.

The outdoor unit of the air conditioner according to an example embodiment may include: a case, a locker disposed in the case, and a board frame configured to move relative to the case and on which the printed circuit board is mounted. The board frame may be configured to slide relative to the case between the first frame position in which the rotational movement with respect to the case is restricted by the locker and the second frame position separated from the locker. In response to the board frame being at the second frame position, the board frame may be configured to rotate about the rotation axis passing through the inside of the case.

The locker may protrude from the inner wall of the case toward the board frame. The board frame may further include a locking hole configured to allow the locker to be locked and coupled thereto in response to the board frame being at the first frame position.

The outdoor unit of the air conditioner may further include guide shafts extending in the direction parallel to the rotation axis of the board frame, and configured to guide the sliding movement of the board frame between the first frame position and the second frame position. The board frame may be configured to rotate relative to the case about the guide shaft in response to the board frame rotating at the second frame position.

The board frame may include guide holes through which the guide shaft passes. The guide hole may extend along the direction in which the board frame slides with respect to the guide shaft.

The outdoor unit of the air conditioner according to an example embodiment may include: a first printed circuit board, a second printed circuit board, a case accommodating the first printed circuit board and the second printed circuit board, and a board frame configured to support the second printed circuit board and configured to move relative to the case. The board frame may be configured to move in the first direction between the first frame position and the second frame position with respect to the case. At the first frame position, the board frame may be restricted from moving in the second direction perpendicular to the first direction with respect to the case. Between the second frame position and the third frame position, the board frame may be configured to rotate about the rotation axis perpendicular to the first direction and the second direction.

As is apparent from the above description, an outdoor unit of an air conditioner may include a board frame, on which a printed circuit board is additionally mounted, inside a control box, and thus the space utilization of the control box may be improved.

Further, an outdoor unit of an air conditioner may include a board frame of a control box configured to slide and rotate with respect to a case, and thus inspection, replacement, and repair of components in the control box may be easily performed.

Further, an outdoor unit of an air conditioner may include a board frame configured to rotate about a rotation axis passing through an inside of a control box, and thus it is possible to prevent and/or reduce the product from being damaged when performing tasks such as inspection, replacement, and repair of components in the control box.

Further, an outdoor unit of an air conditioner may include a board frame configured to slide and then rotate and thus it is possible to prevent and/or reduce the product from being damaged when performing tasks such as inspection, replacement, and repair of components in a control box.

Further, an outdoor unit of an air conditioner may include a board frame configured to slide relative to a case, and thus accessibility to components within a control box may be improved.

Further, an outdoor unit of an air conditioner may include a board frame configured to rotate relative to a case, and thus accessibility to components within a control box may be improved.

Further, an outdoor unit of an air conditioner may restrict a movement of a board frame using a locker, and thus the number of components in a control box may be reduced, and the overall manufacturing process may be simplified by reducing a process for fixing the board frame.

While the present disclosure has been illustrated and described with reference to various example embodiments, it will be understood that the various example embodiments are intended to be illustrative, not limiting. It will be further understood by those skilled in the art that various changes in form and detail may be made without departing from the true spirit and full scope of the present disclosure, including the appended claims and their equivalents. It will also be understood that any of the embodiment(s) described herein may be used in conjunction with any other embodiment(s) described herein.

## Claims

1. An outdoor unit of an air conditioner comprising:
a case;
a board frame configured to move relative to the case and on which a printed circuit board is mounted; and
a frame guide disposed inside the case and configured to support the board frame,
wherein the board frame is configured to slide between a first frame position with respect to the frame guide and a second frame position with respect to the frame guide, and configured to allow a sliding movement of the board frame to be guided by the frame guide,
wherein in response to the board frame being at the second frame position with respect to the frame guide, the board frame is configured to rotate about a rotation axis passing through the frame guide.

2. The outdoor unit of the air conditioner of claim 1, wherein
the case comprises a first inner wall and a second inner wall disposed to face the first inner wall,
wherein the board frame is configured to slide in a direction from the first inner wall to the second inner wall from the first frame position to the second frame position.

3. The outdoor unit of the air conditioner of claim 1, further comprising:
a locker disposed inside the case,
wherein in response to the board frame being at the first frame position with respect to the frame guide, the locker is configured to be locked and coupled to the board frame to restrict the board frame from rotating about the rotation axis,
wherein in response to the board frame moving from the first frame position to the second frame position with respect to the frame guide, the locker is configured to release the locking connection between the board frame.

4. The outdoor unit of the air conditioner of claim 3, wherein
in response to the board frame being at the first frame position with respect to the frame guide, the locker is configured to restrict the board frame from moving in a direction perpendicular to a sliding direction between the first frame position with respect to the frame guide and the second frame position with respect to the frame guide and a direction in which the rotation axis extends.

5. The outdoor unit of the air conditioner of claim 4, wherein
the locker protrudes from an inner wall of the case toward the board frame,
wherein the board frame further comprises a locking hole configured to receive the locker and to lock and couple the locker in response to the board frame being at the first frame position with respect to the frame guide.

6. The outdoor unit of the air conditioner of claim 5, wherein
the board frame comprises a mounting surface on which the printed circuit board is mounted, and a support surface connected to the mounting surface and facing a direction different from a direction in which the mounting surface faces,
wherein the locking hole has a shape penetrating the support surface.

7. The outdoor unit of the air conditioner of claim 1, wherein
the frame guide comprises a guide shaft extending in a direction parallel to the rotation axis,
wherein the guide shaft is configured to guide a sliding movement of the board frame in response to the board frame moving between the first frame position with respect to the frame guide and the second frame position with respect to the frame guide,
wherein the board frame is configured to rotate about the guide shaft in response to the board frame rotating at the second frame position with respect to the frame guide.

8. The outdoor unit of the air conditioner of claim 7, wherein
the board frame comprises a guide hole through which the guide shaft passes,
wherein the guide hole extends along a direction in which the board frame is configured to slide with respect to the guide shaft.

9. The outdoor unit of the air conditioner of claim 8, wherein
one end of both ends of the guide hole in a direction in which the board frame is configured to slide with respect to the guide shaft, is in contact with the guide shaft in response to the board frame being at the first frame position,
wherein another end of the guide hole is in contact with the guide shaft in response to the board frame being at the second frame position.

10. The outdoor unit of the air conditioner of claim 1, wherein
the frame guide comprises an end guide configured to guide a movement of one end of the board frame inside the case,
wherein the one end of the board frame is configured to move along the end guide in response to the board frame rotating about the rotation axis.

11. The outdoor unit of the air conditioner of claim 1, wherein
the board frame is configured to rotate in a first rotation direction from the second frame position with respect to the frame guide toward a third frame position,
wherein the frame guide further comprises:
a block portion in contact with the board frame and configured to restrict the board frame from rotating from the third frame position to the first rotation direction in response to the board frame being at the third frame position.

12. The outdoor unit of the air conditioner of claim 1, wherein
the board frame is configured to rotate in a first rotation direction from the second frame position with respect to the frame guide toward a third frame position,
wherein the frame guide comprises:
a frame support portion configured to support one surface of the board frame; and
an interference protrusion protruding from the frame support portion,
wherein the interference protrusion is configured to interfere with the board frame to restrict the board frame from rotating in a second rotation direction opposite to the first rotation direction from the third frame position in response to the board frame being at the third frame position.

13. The outdoor unit of the air conditioner of claim 12, wherein
the board frame comprises a guide hole formed on one surface facing the frame support portion,
wherein the interference protrusion is configured to be inserted into the guide hole in response to the board frame being at the third frame position.

14. The outdoor unit of the air conditioner of claim 12, wherein
the board frame is configured to move linearly along a direction of the rotation axis in response to the board frame being positioned between the second frame position and the third frame position,
wherein the interference protrusion comprises a chamfer portion inclined with respect to the frame support portion and configured to guide the board frame to move toward a direction away from the frame support portion in response to the board frame moving in the first rotation direction from an intermediate position between the second frame position and the third frame position.

15. The outdoor unit of the air conditioner of claim 1, wherein
the frame guide comprises a first frame guide and a second frame guide disposed to be spaced apart from the first frame guide,
wherein the first frame guide and the second frame guide face each other along a direction parallel to the rotation axis of the board frame.
